# EUROPEAN PATENT APPLICATION

(11) **EP 2 949 897 A1**
(43) Date of publication of application: **02.12.2015**
(21) Application number: 15164987.8
(22) Date of filing: 24.04.2015
(51) Int. Cl.: F01N 5/02, F01N 13/18, H01L 35/30

(54) **THERMOELECTRIC GENERATOR**

(30) Priority: 15.05.2014 JP 2014101300
(71) Applicant: Toyota Jidosha Kabushiki Kaisha, Toyota-shi, Aichi 471-8571 (JP)
(72) Inventor: Iriyama, Yojiro, Toyota-shi,, Aichi 471-8571 (JP)
(74) Representative: TBK

(57) **Abstract**

A thermoelectric generator (2) that generates electricity using heat energy of exhaust gas, the thermoelectric generator comprising: an inflow portion (3B) into which exhaust gas flows from an exhaust passage; an outflow portion (3C) out of which exhaust gas flows; a branch passage (3A) that carries exhaust gas that has flowed in from the inflow portion toward the outflow portion; a plurality of thermoelectric modules (51,52,53,54,55,56) arranged inside the branch passage, a length direction of each thermoelectric module of the plurality of thermoelectric modules being the same direction as a flow direction of exhaust gas in the exhaust passage, the plurality of thermoelectric modules being arranged in series in an exhaust gas flow direction from the inflow portion toward the outflow portion; and at least one wall (3a,3b,3c,32,32A) that defines the branch passage, and the at least one wall being such that exhaust gas flows along both sides of the at least one wall.

## Description

### BACKGROUND OF THE INVENTION

### 1. Field of the Invention

The invention relates to a thermoelectric generator.

### 2. Description of Related Art

A contributed article in the September 2013 issue of Automobiltechnische Zeitschrift (ATZ), pp 714 to 719, describes a thermoelectric generator that generates electricity by recovering heat energy from exhaust gas discharged from an internal combustion engine (hereinafter, also referred to simply as "engine") mounted in a vehicle or the like.

This thermoelectric generator includes a plurality of thermoelectric modules, e.g., cartridge type thermoelectric modules. Each thermoelectric module has a circular cylindrical shape, for example. Each thermoelectric module has an inner pipe through which coolant flows, an output pipe through which the inner pipe is inserted, and multiple thermoelectric conversion elements arranged between the inner pipe and the outer pipe. Also, the outer pipe (a heat receiving portion) is heated by the exhaust gas, and the inner pipe (a heat dissipating portion) is cooled by the coolant. As a result, a temperature difference is created between one side (the heat receiving portion side) and the other side (the heat dissipating portion side) of the thermoelectric conversion elements, and electricity is generated by the Seebeck effect in the thermoelectric conversion element.

As one arrangement of these thermoelectric modules, the contributed article in the September 2013 issue of Automobiltechnische Zeitschrift (ATZ), pp 714 to 719, describes a structure in which a plurality of thermoelectric modules that extend in the extending direction of an exhaust passage are arranged in a circumferential direction on an outer peripheral side of the exhaust passage. Exhaust gas that has flowed through the exhaust passage is divided into a plurality of flows, and each flow of the divided exhaust gas flows separately along an outer peripheral surface of a corresponding thermoelectric module.

### SUMMARY OF THE INVENTION

The thermoelectric generator described on pages 714 to 719 of the contributed article in the September 2013 issue of Automobiltechnische Zeitschrift (ATZ) described above is configured such that the exhaust gas is divided into a plurality of flows, and each flow of the divided exhaust gas flows separately along the outer peripheral surface of a corresponding thermoelectric module. Therefore, a sufficient exhaust gas flow rate per thermoelectric module may be unable to be obtained. Consequently, a sufficient amount of waste heat may not be able to be recovered. This is because when the exhaust gas is divided, a sufficient mass flow rate of exhaust gas per thermoelectric module (i.e., the mass of exhaust gas that flows around the outer periphery of the thermoelectric module per unit of time) is unable to be obtained. As the flow rate of exhaust gas that flows along the outer periphery of the thermoelectric module increases and the mass flow rate of exhaust gas becomes larger, a boundary film heat resistance around the outer periphery of the thermoelectric module decreases, so a large amount of waste heat is able to be recovered. However, when the exhaust gas is divided into a plurality of flows and each flow of the divided exhaust gas flows separately along the outer peripheral surface of a corresponding thermoelectric module as described above, the mass flow rate of exhaust gas that flows along the outer periphery of the thermoelectric module is small, so the boundary film heat resistance increases, and as a result, a sufficient amount of waste heat may be unable to be recovered.

The invention thus provides a thermoelectric generator capable of increasing the amount of waste heat that is recovered.

In the invention, a thermoelectric generator includes a thermoelectric module that extends in the same direction as the flow direction of exhaust gas in an exhaust passage. Therefore, a length dimension of the thermoelectric module is able to be long, and exhaust gas that has flowed in through the exhaust passage flows in order over a plurality of thermoelectric modules. In this way, a sufficient exhaust gas flow rate per thermoelectric module is able to be obtained, so a sufficient amount of waste heat is able to be recovered. Moreover, the exhaust gas flows along both surfaces of a wall that forms a thermoelectric module housing space (i.e., a space through which exhaust gas for heating the thermoelectric modules flows). As a result, the amount of heat from the exhaust gas that flows through this thermoelectric module housing space that is dissipated to the outside air is able to be reduced, so a sufficient amount of waste heat is able to be recovered.

A first aspect of the invention relates to a thermoelectric generator that generates electricity using heat energy of exhaust gas that flows through an exhaust system of an internal combustion engine. This thermoelectric generator includes an inflow portion into which exhaust gas flows from an exhaust passage of the exhaust system; an outflow portion out of which exhaust gas flows; a branch passage that carries exhaust gas that has flowed in from the inflow portion toward the outflow portion; a plurality of thermoelectric modules that are arranged inside the branch passage, a length direction of each thermoelectric module of the plurality of thermoelectric modules being the same direction as a flow direction of exhaust gas in the exhaust passage, the plurality of thermoelectric modules being arranged in series in an exhaust gas flow direction from the inflow portion toward the outflow portion; and at least one wall that defines the branch passage, and the at least one wall being such that exhaust gas flows along both sides of the at least one wall.

According to this structure, exhaust gas that has flowed from the exhaust passage of the exhaust system into the branch passage through the inflow portion flows through this branch passes from the inflow portion toward the outflow portion. The thermoelectric modules are arranged in series in the flow direction of the exhaust gas, so almost all of the exhaust gas that flows through the branch passage flows in order around the outer peripheries of the thermoelectric modules. That is, almost all of the exhaust gas imparts heat in order to each of the thermoelectric modules. Therefore, a sufficient exhaust gas flow rate per thermoelectric module is able to be obtained. Also, a sufficient exhaust gas flow rate per thermoelectric module is able to be obtained compared to when the exhaust gas is divided and flows separately to each thermoelectric module. As a result, a sufficient amount of waste heat is able to be recovered. That is, compared to the technology described on pages 714 to 719 of the contributed article in the September 2013 issue of Automobiltechnische Zeitschrift (ATZ), the flow rate of exhaust gas that flows along the outer periphery of each thermoelectric module is increased, and the mass flow rate of exhaust gas is greater. Consequently, the boundary film heat resistance around the outer periphery of each thermoelectric module is smaller, so the amount of waste heat that is recovered is able to be increased.

According to the structure described above, the thermoelectric modules are arranged in the branch passage such that the length direction of the thermoelectric modules is the same direction as the flow direction of exhaust gas in the exhaust passage. Therefore, the length dimension of the thermoelectric modules is not greatly restricted, so the length dimension of the thermoelectric modules can be set relatively long (i.e., the length dimension of the thermoelectric modules can be set relatively long compared to when the length direction of the thermoelectric modules is set to a direction orthogonal to the flow direction of exhaust gas in the exhaust passage). Thus, the amount of waste heat recovered per thermoelectric module is able to be increased, so the amount of waste heat that is recovered for the entire thermoelectric generator is able to be increased.

Moreover, exhaust gas flows along both sides of at least a portion of a wall, of the walls that form the branch passage, so almost no heat is dissipated to the outside air from the wall, and consequently, a decrease in the exhaust gas temperature caused by heat dissipation to the outside air is also reduced. Therefore, the amount of heat imparted to the thermoelectric modules increases, which also enables the amount of waste heat that is recovered to be increased.

In the thermoelectric generator described above, the exhaust gas flow direction from the inflow portion toward the outflow portion in the branch passage may be a direction that intersects the flow direction of exhaust gas in the exhaust passage, and the plurality of thermoelectric modules that are arranged in the branch passage may be arranged in series in the direction that intersects the flow direction of exhaust gas in the exhaust passage.

In the thermoelectric generator described above, the exhaust gas flow direction from the inflow portion toward the outflow portion in the branch passage may be the same direction as the flow direction of exhaust gas in the exhaust passage, and the plurality of thermoelectric modules that are arranged in the branch passage may be arranged in series in the same direction as the flow direction of exhaust gas in the exhaust passage.

According to this structure, the thermoelectric modules are able to be arranged in a manner suited to the flow direction of exhaust gas in the branch passage.

In the thermoelectric generator described above, each of the thermoelectric modules may include a plurality of heat receiving fins on an outer surface of each of the thermoelectric modules, and the plurality of heat receiving fins may be provided in the flow direction of exhaust gas in the branch passage.

According to this structure, exhaust gas that has flowed in toward the thermoelectric modules flows along the heat receiving fins without the flow direction of the exhaust gas changing direction much, so the heat receiving fins are able to be inhibited from becoming resistance to the flow of exhaust gas. Therefore, the flow rate of exhaust gas that flows between the heat receiving fins is able to be kept high. As a result, the boundary film heat resistance around the outer peripheries of the thermoelectric modules is able to be kept low, so the amount of waste heat that is recovered is able to be increased.

In the thermoelectric generator described above, the branch passage may include an upstream side passage and a downstream side passage, the upstream side passage carries exhaust gas that has flowed in from the exhaust passage through the inflow portion in one direction, the downstream side passage carries exhaust gas that has flowed through the upstream side passage toward the outflow portion in the opposite direction of the flow in the upstream side passage; and the upstream side passage and the downstream side passage may be adjacent to each other, with the at least one wall between the upstream side passage and the downstream side passage, in a direction orthogonal to the flow direction of exhaust gas in the upstream side passage and the flow direction of exhaust gas in the downstream side passage.

The thermoelectric generator described above may also include a casing that defines the branch passage. The at least one wall may be a partition that partitions an inside of the casing into the upstream side passage and the downstream side passage, the upstream side passage and the downstream side passage may be communicated by a communication path arranged between the partition and a casing inside surface, and exhaust gas that has flowed into the upstream side passage through the inflow portion may flow into the downstream side passage through the communication path.

The thermoelectric generator described above may also include a casing that defines the branch passage. The at least one wall may be a partition that partitions an inside of the casing into the upstream side passage and the downstream side passage, the upstream side passage and the downstream side passage may be communicated by a communication hole arranged in the partition, and exhaust gas that has flowed into the upstream side passage through the inflow portion may flow into the downstream side passage through the communication hole.

According to this structure, the upstream side passage and the downstream side passage are adjacent to each other, with the wall therebetween, in a direction orthogonal to the flow direction of exhaust gas. That is, in a structure provided with the partition, the passages are adjacent to each other with the partition therebetween. As a result, a region that is not exposed to outside air is able to be provided at the wall that forms the branch passage, so a decrease in exhaust gas temperature caused by heat dissipating to the outside air is able to be suppressed, by a relatively simple structure.

In the thermoelectric generator described above, the inflow portion and the outflow portion may be provided in positions offset from each other in the same direction as the flow direction of exhaust gas in the exhaust passage.

In the thermoelectric generator described above, the at least one wall provided with the inflow portion may be facing the exhaust passage.

According to this structure, the region that is not exposed to outside air, of the wall that forms the branch passage, is able to be relatively large, so a decrease in exhaust gas temperature caused by heat dissipating to the outside air is able to be inhibited, which enables the amount of waste heat that is recovered to be increased.

In the thermoelectric generator described above, the branch passage may be configured to cover outer periphery of a portion of the exhaust passage, and the at least one wall is disposed on the exhaust passage side, and the at least one wall may face the exhaust passage.

In the thermoelectric generator described above, the branch passage may be configured to cover an outer periphery of a portion of the exhaust passage along an entire circumferential direction of the exhaust passage; and the at least one wall is disposed on the exhaust passage side, and the entire area of the at least one faces the exhaust passage.

According to this structure, the region that is not exposed to outside air, of the wall that forms the branch passage, is able to be relatively large. As a result, a decrease in exhaust gas temperature caused by heat dissipating to the outside air is able to be inhibited, so the amount of waste heat that is recovered is able to be increased.

In the thermoelectric generator described above, the inflow portion may be an opening that extends in the flow direction of exhaust gas in the exhaust passage.

In the thermoelectric generator described above, the inflow portion may be configured by a plurality of openings that are disposed in a plurality of locations in the flow direction of exhaust gas in the exhaust passage.

The thermoelectric generator described above may also include a rectifying member that is provided between the inflow portion and a thermoelectric module, of the plurality of the thermoelectric module, arranged in a position farthest upstream in the flow direction of exhaust gas in the branch passage. The rectifying member may be configured to rectify the flow of exhaust gas that flows from the inflow portion toward the thermoelectric module.

The thermoelectric generator described above may also include a restricting member that is provided in the exhaust passage, and covers an upstream side region, in the exhaust gas flow direction in the exhaust passage, of an open area of the inflow portion, and exposes a downstream side region, in the flow direction of exhaust gas of the exhaust passage, of the open area of the inflow portion.

According to this structure, exhaust gas is able to flow through a relatively wide area of the branch passage. As a result, the amount of waste heat that is recovered per thermoelectric module is able to be increased, so the amount of waste heat that is recovered for the entire thermoelectric generator is able to be increased.

The thermoelectric generator described above may also include an on-off valve that is provided in the exhaust passage on a downstream side, in the flow direction of exhaust gas, of a position where the inflow portion is arranged in the exhaust passage, and the on-off valve may be configured to open and close the exhaust passage.

The thermoelectric generator described above may also include a return duct, and on-off valve and an electronic control unit. The return duct may be provided between the exhaust passage and the outflow portion of the branch passage. The return duct may be configured to return exhaust gas that has flowed out from the outflow portion to the exhaust passage. The on-off valve may be provided in the exhaust passage on a downstream side, in the flow direction of exhaust gas, of a position where the inflow portion is arranged in the exhaust passage. The electronic control unit may be configured to shut off a communication between the return duct and the exhaust passage by the on-off valve when opening the exhaust passage, and communicate the return duct with the exhaust passage by the on-off valve when closing the exhaust passage.

According to this structure, the amount of exhaust gas that flows into the branch passage is able to be regulated by the opening of the on-off valve. Therefore, exhaust gas of an amount suitable to generate electricity in the thermoelectric modules is able to flow to the branch passage.

According to the structure described above, the plurality of thermoelectric modules are arranged in series in the exhaust gas flow direction from the inflow portion toward the outflow portion, which enables a sufficient exhaust gas flow rate per thermoelectric module to be obtained, and as a result, the amount of waste heat that is recovered is able to be increased.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is a block diagram schematically showing an exhaust duct and a thermoelectric generator according to a first example embodiment of the invention, with thermoelectric modules and an on-off valve indicated by solid lines, and other members indicated by virtual lines;
FIG. 2 is a sectional view of the structure of the inside of an upper passage of the thermoelectric generator according to the first example embodiment, as well as portions therearound;
FIG. 3 is a sectional view of the structure of the inside of a lower passage of the thermoelectric generator according to the first example embodiment, as well as portions therearound;
FIG. 4 is a sectional view of a position corresponding to line IV - IV in FIG. 2;
FIG. 5 is a view from a position corresponding to line V - V in FIG. 2;
FIG. 6 is a sectional view of a position corresponding to line VI - VI in FIG. 2;
FIG. 7 is a sectional view in a direction along an axis of a thermoelectric module according to the first example embodiment;
FIG. 8 is a sectional view in a direction orthogonal to the axis of the thermoelectric module according to the first example embodiment;
FIG. 9A and 9B are views of a state in which exhaust gas is not introduced into the thermoelectric generator according to the first example embodiment, with FIG. 9A being a view corresponding to FIG. 2, and FIG. 9B being a view corresponding to FIG. 4;
FIGS. 10A to 10D are views of a state in which all of the exhaust gas is introduced into the thermoelectric generator according to the first example embodiment, with FIG. 10A being a view corresponding to FIG. 2, FIG. 10B being a view corresponding to FIG. 3, FIG. 10C being a view corresponding to FIG. 4, and FIG 10D being a view corresponding to FIG. 6;
FIGS. 11A to 11C are views of a state in which some of the exhaust gas is introduced into the thermoelectric generator according to the first example embodiment, with FIG. 11A being a view corresponding to FIG. 2, FIG. 11B being a view corresponding to FIG. 3, and FIG. 11C being a view corresponding to FIG. 4;
FIG. 12 is a view illustrating a relationship between a flow rate of exhaust gas that flows near heat receiving fins according to the first example embodiment, and a boundary film around these heat receiving fins;
FIG. 13 is a view illustrating a relationship between a mass flow rate of exhaust gas that flows around the thermoelectric modules according to the first example embodiment, and a boundary film heat resistance around the heat receiving fins;
FIG. 14 is a view illustrating a relationship between the mass flow rate of exhaust gas that flows around the thermoelectric modules according to the first example embodiment, and an electric-generating capacity of the thermoelectric generator;
FIG. 15 is a schematic view of the exhaust duct and the thermoelectric generator arranged below a floor panel according to the first example embodiment;
FIG. 16 is a flowchart illustrating a routine for opening control of the on-off valve according to the first example embodiment;
FIG. 17 is a view of one example of a relationship between an average temperature of a temperature of a heat dissipating board and a temperature of a heat receiving board of a thermoelectric conversion element, and the electric-generating capacity;
FIG. 18 is a view showing a frame format of an arrangement of thermoelectric modules according to related art, and exhaust gas flows that flow around the thermoelectric modules, in a test example;
FIG. 19 is a view showing a frame format of an arrangement of the thermoelectric modules according to the first example embodiment, and an exhaust gas flow that flows around the thermoelectric modules, in a test example;
FIG. 20 is a view showing measurement results of an amount of heat transferred to the thermoelectric modules and the electric-generating capacity of the thermoelectric modules of both the related art and the first example embodiment, in a test example;
FIGS. 21A and 21B are views of a thermoelectric generator according to a second example embodiment of the invention, with FIG. 21A being a view corresponding to FIG. 2, and FIG. 21B being a view corresponding to FIG. 6;
FIG. 22 is a view corresponding to FIG. 2, of a thermoelectric generator according to a third example embodiment of the invention;
FIG. 23 is a view corresponding to FIG. 2, of a thermoelectric generator according to a fourth example embodiment of the invention;
FIG. 24 is a block diagram schematically showing an exhaust duct and a thermoelectric generator according to a fifth example embodiment of the invention, with thermoelectric modules omitted, an on-off valve indicated by a solid line, and other members indicated by virtual lines;
FIG. 25 is a sectional view of a position corresponding to line XXV - XXV in FIG. 24;
FIG. 26 is a sectional view of a position corresponding to line XXVI - XXVI in FIG. 24;
FIG. 27 is a block diagram schematically showing an exhaust duct and a thermoelectric generator according to a sixth example embodiment of the invention, with an on-off valve indicated by a solid line, and other members indicated by virtual lines;
FIGS. 28A and 28B are views of a first modified example of an inflow portion and an outflow portion of a thermoelectric generator according to a first modified example, with FIG. 28A being a view corresponding to FIG. 2, and FIG. 28B being a view corresponding to FIG. 3;
FIGS. 29A and 29B are views of a second modified example of an inflow portion and an outflow portion of a thermoelectric generator according to a second modified example, with FIG. 29A being a view corresponding to FIG. 2, and FIG. 29B being a view corresponding to FIG. 3;
FIGS. 30A and 30B are views of a third modified example of an inflow portion and an outflow portion of a thermoelectric generator according to a third modified example, with FIG. 30A being a view corresponding to FIG. 2, and FIG. 30B being a view corresponding to FIG. 3;
FIGS. 31A and 31B are views of a fourth modified example of an inflow portion and an outflow portion of a thermoelectric generator according to a fourth modified example, with FIG. 31A being a view corresponding to FIG. 2, and FIG. 31B being a view corresponding to FIG. 3;
FIGS. 32A and 32B are views of a fifth modified example of an inflow portion and an outflow portion of a thermoelectric generator according to a fifth modified example, with FIG. 32A being a view corresponding to FIG. 2, and FIG. 32B being a view corresponding to FIG. 3;
FIG. 33 is a vies corresponding to FIG. 6, of a first modified example of a casing of a thermoelectric generator according to a sixth modified example; and
FIGS. 34A and 34B are views of a second modified example of a casing of a thermoelectric generator according to a seventh modified example, with FIG. 34A being a view corresponding to FIG. 2, and FIG. 34B being a view corresponding to FIG. 3.

### DETAILED DESCRIPTION OF EMBODIMENTS

Hereinafter, example embodiments of the invention will be described with reference to the accompanying drawings. In the example embodiments below, a case in which the invention is applied to a thermoelectric generator provided in an exhaust system of a vehicle engine (internal combustion engine) will be described. Also, in the example embodiments below, a case in which the invention is applied to a thermoelectric generator provided with circular cylindrical-shaped cartridge type thermoelectric modules will be described.

First, a first example embodiment of the invention will be described.

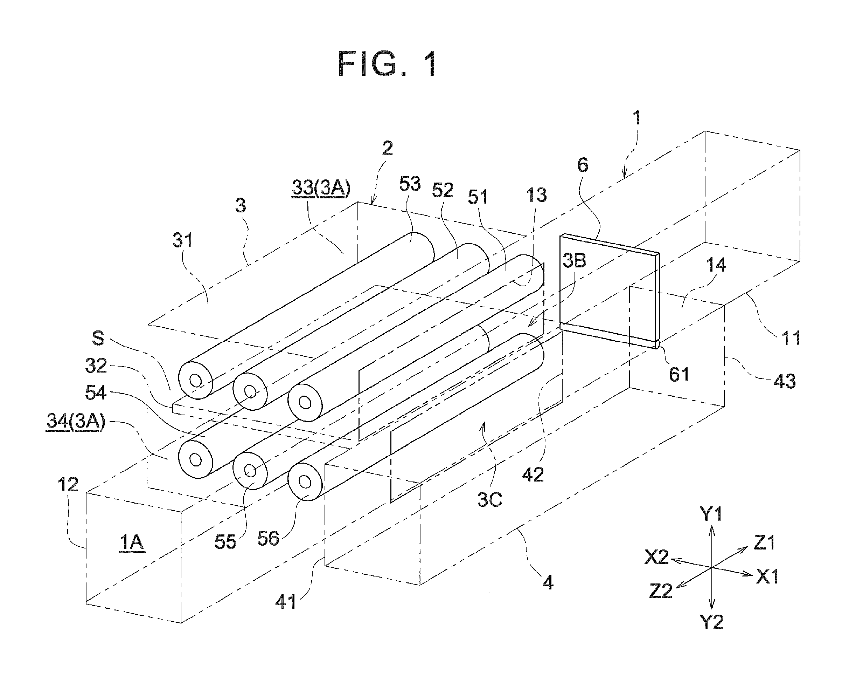

FIG. 1 is a block diagram schematically showing an exhaust duct 1 and a thermoelectric generator 2. An on-off valve 6 and thermoelectric modules (cartridge type thermoelectric modules) 51 to 56 that will be described later are indicated by solid lines, and other members are indicated by virtual lines.

An X direction in FIG. 1 is a vehicle width direction, a Y direction is a height direction (vertical direction), and a Z direction is a vehicle body longitudinal direction. Also, in the description below, the vehicle body left side (i.e., the right side in FIG. 1) in the X direction (the vehicle width direction) will be referred to as the "X1 direction", and the vehicle body right side (i.e., the left side in FIG. 1) will be referred to as the "X2 direction". Also, the upper side in the Y direction (the height direction) will be referred to as the "Y1 direction", and the lower side will be referred to as the "Y2 direction". Further, the vehicle body rear side (i.e., the far side in the drawing) in the Z direction (the vehicle body longitudinal direction) will be referred to as the "Z1 direction", and the vehicle body front side (the near side in the drawing) will be referred to as the "Z2 direction".

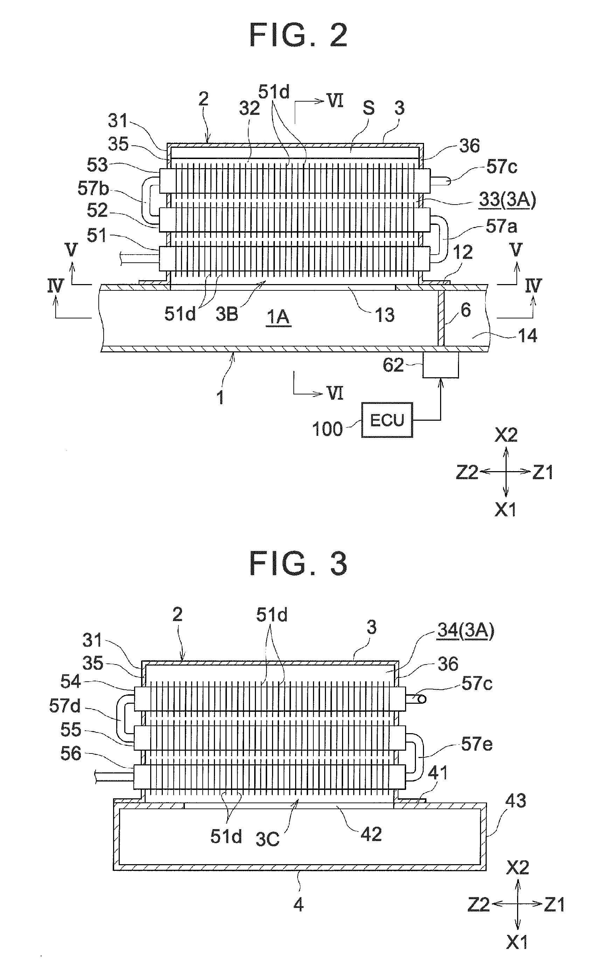

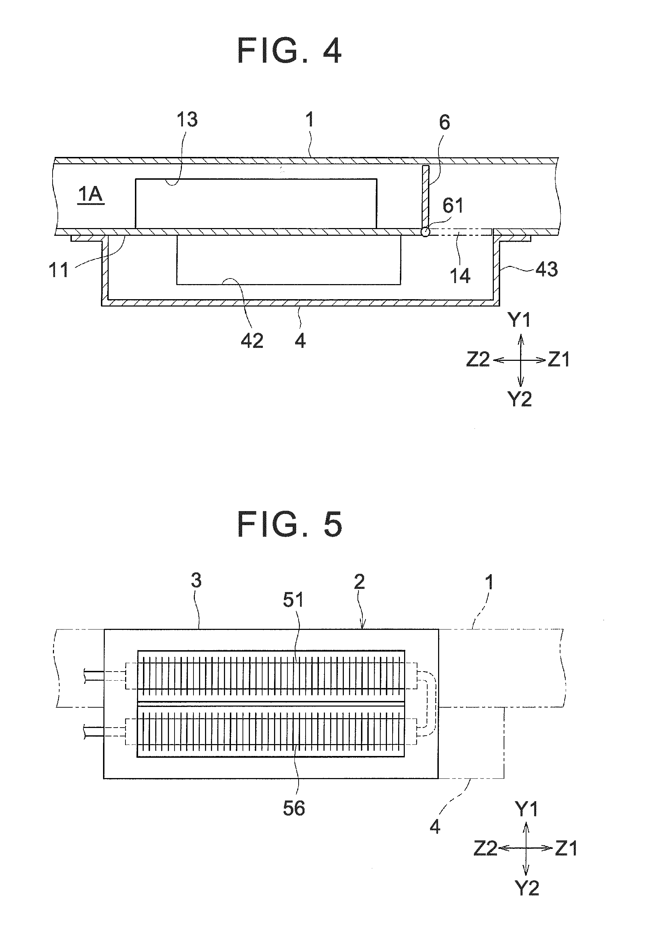

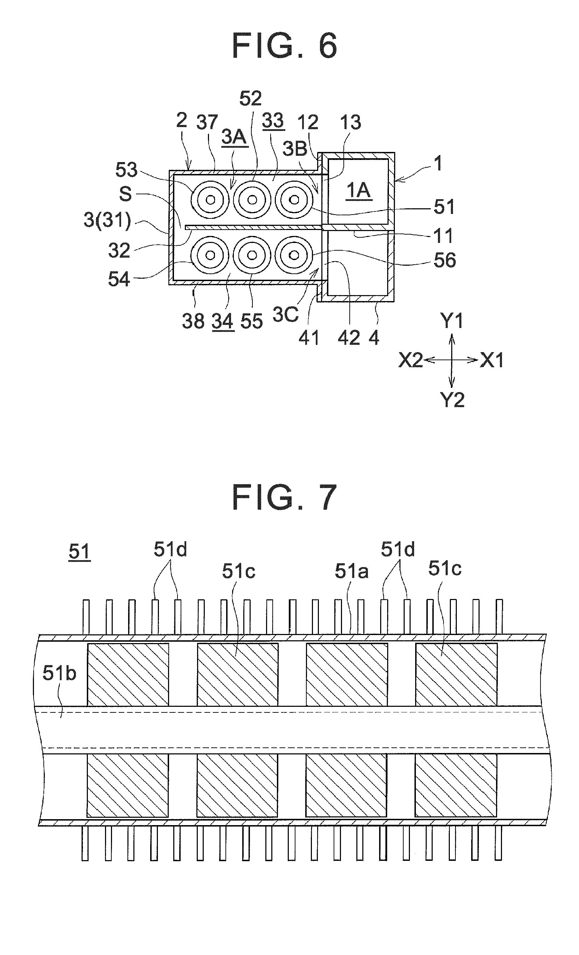

FIG. 2 is a sectional view of the structure of the inside of an upper passage 33, to be described later, of the thermoelectric generator 2, as well as portions therearound. That is, FIG. 2 is a view of the inside of the upper passage 33 and the portions therearound from above. FIG. 3 is a sectional view of the structure of the inside of a lower passage 34, to be described later, of the thermoelectric generator 2, as well as portions therearound. That is, FIG. 3 is a view of the inside of the lower passage 34 and the portions therearound from above. FIG. 4 is a sectional view of a position corresponding to line IV - IV in FIG. 2. FIG. 5 is a view from a position corresponding to line V - V in FIG. 2. FIG. 6 is a sectional view of a position corresponding to line VI - VI in FIG. 2.

As shown in FIGS. 1 to 6, the thermoelectric generator 2 is integrally attached to the exhaust duct 1. Also, this thermoelectric generator 2 includes an apparatus main body 3 and a return duct 4 for returning exhaust gas that has flowed out from this apparatus main body 3, to the exhaust duct 1.

The return duct 4 is integrally attached to a lower surface 11 (i.e., a surface positioned on the Y2 direction side) of the exhaust duct 1. The apparatus main body 3 is integrally attached to a side surface 12 (i.e., a side surface positioned on the X2 direction side) of the exhaust duct 1, and a side surface 41 (i.e., a side surface positioned on the X2 direction side) of the return duct 4. That is, the apparatus main body 3 is arranged from the side surface 12 of the exhaust duct 1 to the side surface 41 of the return duct 4, with the upper half of this apparatus main body 3 being integrally attached to the side surface 12 of the exhaust duct 1, and the lower half of the apparatus main body 3 being integrally attached to the side surface 41 of the return duct 4.

Hereinafter, each of the members will be described in detail.

As shown in FIGS. 1, 2, 4, and 6, the exhaust duct 1 that forms an exhaust passage 1A of an exhaust system is arranged extending in a vehicle body longitudinal direction (the Z direction), with an end portion on the vehicle body front side (an end portion on the Z2 direction side) being connected to an exhaust manifold, not shown, of an engine. Therefore, the exhaust duct 1 carries exhaust gas discharged from the engine toward the rear of the vehicle body (the Z1 direction side) and discharges it into the atmosphere. A catalytic converter and a muffler, neither of which are shown, are provided in the exhaust duct 1.

The exhaust duct 1 in this example embodiment has a cross-section (i.e., a cross-section in a direction orthogonal to the length direction (the Z direction) of the exhaust duct 1) that has a rectangular shape. This exhaust duct 1 may also have a cross-section that has a circular or elliptical shape.

An opening 13 that allows exhaust gas to flow into the apparatus main body 3 of the thermoelectric generator 2 is formed in the side surface 12 (i.e., a side surface positioned on the X2 direction side) of the exhaust duct 1. A length of the opening 13 in the vehicle body longitudinal direction is set slightly shorter than the length of the apparatus main body 3 in the vehicle body longitudinal direction.

An opening 14 is formed in the lower surface 11 (i.e., the surface positioned on the Y2 direction side) of the exhaust duct 1, in a position facing an end portion on the vehicle body rear side (i.e., an end portion on the Z1 direction side) of the return duct 4. This opening 14 is designed to allow exhaust gas returned from the return duct 4 to flow into the exhaust passage 1A.

The apparatus main body 3 of the thermoelectric generator 2 is configured such that a plurality of thermoelectric modules 51 to 56 are arranged inside of a branch passage 3A (i.e., a passage that branches off from the exhaust passage 1A provided inside the exhaust duct 1) that is provided inside of a casing 31.

The casing 31 has a rectangular parallelepiped shape. As shown in FIGS. 1, 2, and 6, a partition 32 that vertically partitions an internal space of the casing 31 is provided in a generally center portion in the height direction (the Y direction) of this casing 31. An X2 direction-side end edge of the partition 32 is positioned such that there is a predetermined distance between it and an inside surface of the casing 31 (i.e., an inside surface positioned on the X2 direction side). The other end edge of the partition 32 is connected to an inside surface of the casing 31. Therefore, the passage 33 on the upper side and the passage 34 on the lower side inside the casing 31 that are partitioned by the partition 32 are communicated by only a communication path S formed between the X2 direction-side end edge of the partition 32 and the inside surface of the casing 31. Hereinafter, this passage 33 on the upper side will be referred to as the "upper passage 33 (upstream side passage)", and the passage 34 on the lower side will be referred to as the "lower passage 34 (downstream side passage)". As a result, the branch passage 3A from the upper passage 33 through which exhaust gas flows, to the lower passage 34, is formed in the casing 31.

The partition 32 forms a bottom plate of the upper passage 33 and a top plate of the lower passage 34. Therefore, the partition 32 is a wall that forms the branch passage, and a wall on both sides of which exhaust gas flows.

As shown in FIG. 6, the X1 direction side of the casing 31 is open. Therefore, the upper passage 33 of the casing 31 faces the opening 13 formed in the exhaust duct 1. The upper passage 33 is communicated with the exhaust passage 1A via the opening 13. That is, exhaust gas is able to flow into the upper passage 33 from the exhaust duct 1. Therefore, an inflow portion 3B of the branch passage 3A is formed by an open portion of the casing 31 on the X1 direction side and the opening 13. Exhaust gas is able to flow into the branch passage 3A from the exhaust passage 1A via the inflow portion 3B. The inflow portion 3B is formed by an opening that extends relatively long in the flow direction of exhaust gas in the exhaust passage 1A.

As described above, the plurality of thermoelectric modules 51 to 56 are arranged in the branch passage 3A that is provided inside the casing 31. In the thermoelectric generator 2 according to this example embodiment, there are a total of six thermoelectric modules 51 to 56, three being arranged in the upper passage 33 of the casing 31 and three being arranged in the lower passage 34 of the casing 31.

The three thermoelectric modules 51, 52, and 53 that are arranged in the upper passage 33 are arranged with their axes extending in the Z direction, and are lined up in order in the X direction. Here, the thermoelectric modules 51, 52, and 53, from the thermoelectric module 51 arranged on the X1 direction side to the thermoelectric modules 52 and 53 arranged on the X2 direction side, will be referred to in order as the "first thermoelectric module 51", the "second thermoelectric module 52", and the "third thermoelectric module 53".

Similarly, the three thermoelectric modules 54, 55, and 56 that are arranged in the lower passage 34 are arranged with their axes extending in the Z direction, and are lined up in order in the X direction. Here, the thermoelectric modules 54, 55, and 56, from the thermoelectric module 54 arranged on the X2 direction side to the thermoelectric modules 55 and 56 arranged on the X1 direction side, will be referred to in order as the "fourth thermoelectric module 54", the "fifth thermoelectric module 55", and the "sixth thermoelectric module 56".

Front end portions (i.e., end portions on the Z2 direction side) of the thermoelectric modules 51 to 56 in the length direction thereof pass through a front plate 35 positioned on the Z2 direction side of the casing 31, and are supported by this front plate 35. Similarly, rear end portions (i.e., end portions on the Z1 direction side) of the thermoelectric modules 51 to 56 pass through a rear plate 36 positioned on the Z1 direction side of the casing 31, and are supported by this rear plate 36.

In this way, the thermoelectric modules 51 to 56 are arranged inside the branch passage 3A in such a manner that the length direction of the thermoelectric modules 51 to 56 is the same as the flow direction of exhaust gas in the exhaust passage 1A (i.e., the length direction of the exhaust duct 1). The thermoelectric modules 51 to 56 are arranged in series in an exhaust gas flow direction from the inflow portion 3B toward an outflow portion 3C that will be described later. The exhaust gas flow direction from the inflow portion 3B toward the outflow portion 3C is the X direction, i.e., a direction that intersects the flow direction of exhaust gas in the exhaust passage 1A.

Here, the structure of the thermoelectric modules 51 to 56 will be described. The structures of the thermoelectric modules 51 to 56 are the same, so the first thermoelectric module 51 will be described here as a representative.

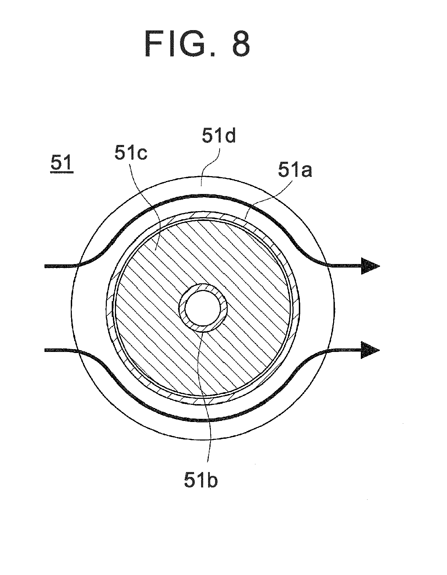

FIG. 7 is a sectional view in a direction along the axis of the first thermoelectric module 51. FIG. 8 is a sectional view in a direction orthogonal to the axis of the first thermoelectric module 51.

The thermoelectric module 51 generates electricity using the heat energy of exhaust gas. The thermoelectric module 51 includes an outer pipe 51a, an inner pipe 51b, a module main body 51c, and heat receiving fins 51d.

The module main body 51c is formed in a cylindrical shape. The inner pipe 51b is inserted inside the module main body 51c. The module main body 51c is configured with a plurality of N type thermoelectric conversion elements and P type thermoelectric conversion elements (neither of which are shown) that generate electromotive force corresponding to a temperature difference by the Seebeck effect, arranged between a heat receiving board made of insulating ceramics that forms a high temperature portion, and a heat dissipating board made of insulating ceramics that forms a low temperature portion. The heat receiving board is provided on an outer peripheral portion of the module main body 51c. The heat dissipating board is provided on an inner peripheral portion of the module main body 51c. The module main body 51c of this example embodiment is formed as a π type module in which a plurality of thermoelectric conversion units formed from the heat receiving board, the heat dissipating board, and the thermoelectric conversion element are electrically connected together in series. Although not shown, a plurality of the module main bodies 51c are electrically connected together. A Bi-Te type thermoelectric conversion element in which the operating upper limit value (upper temperature limit) of the high temperature portion is approximately 300°C, or a Si-Ge type thermoelectric conversion element in which the operating upper limit of the high temperature portion is approximately 500°C, or the like, for example, may be used as the N type thermoelectric conversion element and the P type thermoelectric conversion element. A description of the structures of these boards and thermoelectric conversion elements will be omitted here.

The inner pipe 51b is inserted inside the module main body 51c, as described above, and the inside of the module main body 51c, i.e., the heat dissipating board, is cooled by coolant flowing through the inside of the inner pipe 51b. Engine coolant, for example, may be used as the coolant. That is, the inner pipe 51b branches off from a coolant circulation circuit of the engine, and the heat dissipating board is cooled by some of the coolant that flows through this coolant circulation circuit flowing into the inner pipe 51b as needed. The coolant that flows through the inside of the inner pipe 51b is not limited to engine coolant.

The sectional shape of the first thermoelectric module 51 in a direction orthogonal to its axis is not limited to circular, and may alternatively be elliptical or polygonal.

The inner pipes of the thermoelectric modules 51 to 56 are connected in series such that the coolant flows from the first thermoelectric module 51 toward the sixth thermoelectric module 56 in order. More specifically, as shown in FIGS. 2 and 3, the inner pipes of the thermoelectric modules 51 to 56 are connected by connecting pipes 57a to 57e.

The direction in which the coolant flows may be from the sixth thermoelectric module 56 toward the first thermoelectric module 51 in this order. The inner pipes of the thermoelectric modules 51 to 56 are not limited to being connected in series, and may alternatively be connected in parallel.

The heat receiving fins 51d are integrally formed on an outer peripheral surface of the outer pipe 51a. The heat receiving fins 51d are formed by metal plates that extend in a direction substantially orthogonal to the axis of the thermoelectric module 51 and which have generally circular outer edges. The heat receiving fins 51d are arranged at predetermined pitches in the length direction of the thermoelectric module 51. In this way, the heat receiving fins 51d are provided in a direction following the flow direction of exhaust gas in the branch passage 3A.

Heat receiving fins 51d formed on adjacent thermoelectric modules 51 to 56 are provided in corresponding positions in the X direction. That is, the heat receiving fins 51d are arranged in positions where the phases in the Z direction match.

This kind of arrangement of the heat receiving fins 51d results in the exhaust gas flowing generally in the direction in which the heat receiving fins 51d extend. Therefore, the heat receiving fins 51d are able to be inhibited from becoming resistance to the flow of exhaust gas.

The return duct 4 is integrally attached to the lower surface 11 of the exhaust duct 1, as described above. The return duct 4 is formed by a conduit that is closed on the front side (i.e., the Z2 direction side) and on the rear side (i.e., the Z1 direction side). An opening 42 for recovering exhaust gas that has flowed through the branch passage 3A (i.e., inside the casing 31) is provided in the side surface 41 (i.e., the side surface positioned on the X2 direction side) of the return duct 4. The length of this opening 42 in the vehicle body longitudinal direction is set slightly shorter than the length of the apparatus main body 3 in the vehicle body longitudinal direction.

As described above, the X1 direction side of the casing 31 is open. Therefore, the lower passage 34 of the casing 31 faces the opening 42 formed in the return duct 4. The lower passage 34 is communicated with the internal space of the return duct 4 via the opening 42. That is, exhaust gas is able to flow out of the lower passage 34 into the return duct 4. Therefore, the outflow portion 3C of the branch passage 3A is formed by the opening 42 and the open portion on the X1 direction side of the casing 31. The outflow portion 3C enables exhaust gas to flow out from the branch passage 3A.

As described above, the branch passage 3A has the inflow portion 3B and the outflow portion 3C, and exhaust gas that has flowed in from the inflow portion 3B flows toward the outflow portion 3C. That is, exhaust gas that has flowed in from the inflow portion 3B flows through the upper passage 33 and reverses direction when it passes through the communication path S, after which the exhaust gas flows through the lower passage 34 and out from the outflow portion 3C. Therefore, the upper passage 33 and the lower passage 34 that form the branch passage 3A are adjacent to one another, with the partition 32 therebetween, in a direction (the Y direction) that is substantially orthogonal to the flow direction of the exhaust gas in the upper passage 33 and the lower passage 34.

As shown in FIGS. 1 and 4, the opening 13 formed in the exhaust duct 1 is offset in the Z direction from the opening 42 formed in the return duct 4. More specifically, the opening 13 formed in the exhaust duct 1 is positioned farther to the Z2 direction side than the opening 42 formed in the return duct 4. As a result, the inflow portion 3B and the outflow portion 3C are both offset in the Z direction (i.e., in the same direction as the flow direction of the exhaust gas in the exhaust passage 1A).

A rear plate 43 positioned on the Z1 direction side of the return duct 4 is positioned farther to the Z1 direction side, i.e., the downstream side in the flow direction of the exhaust gas in the exhaust passage 1A, than the opening 14 formed in the lower surface 11 of the exhaust duct 1. Therefore, when exhaust gas is recovered from the apparatus main body 3 of the thermoelectric generator 2 to the return duct 4, this exhaust gas is able to flow through the return duct 4 and into the exhaust duct 1 through the opening 14.

In the exhaust passage 1A, the on-off valve 6 is provided near the opening 14, and farther to the downstream side than the opening position of the inflow portion 3B. The on-off valve 6 has a rectangular shape that substantially matches the sectional shape of the exhaust duct 1. The on-off valve 6 is supported by a rotating shaft 61 that is arranged on the bottom plate of the exhaust duct 1 and extends in the X direction. The rotating shaft 61 of the on-off valve 6 is connected to an electric motor 62 (see FIG. 2). The opening of the on-off valve 6 is able to be adjusted by the operation of the electric motor 62. The electric motor 62 operates in response to receiving an opening control signal from an ECU 100, and adjusts the opening of the on-off valve 6. The ECU 100 is an electronic control unit for controlling the engine (i.e., an engine ECU), for example. More specifically, the opening of the on-off valve 6 is able to be adjusted between a fully closed position indicated by the solid line in FIG. 4, and a fully open position indicated by the virtual line in FIG. 4. The fully closed position is a position in which the exhaust passage 1A is in a closed state, and the opening 14 is in an open state. The fully open position is a position in which the exhaust passage 1A is in an open state, and the opening 14 is a closed state.

Next, the flow of exhaust gas in this example embodiment will be described. The flow of exhaust gas in this example embodiment is able to be changed by the opening of the on-off valve 6. The flows of exhaust gas when the on-off valve 6 is in the fully open position, when the on-off valve 6 is in the fully closed position, and when the on-off valve 6 is in a partially open position, will each be described below.

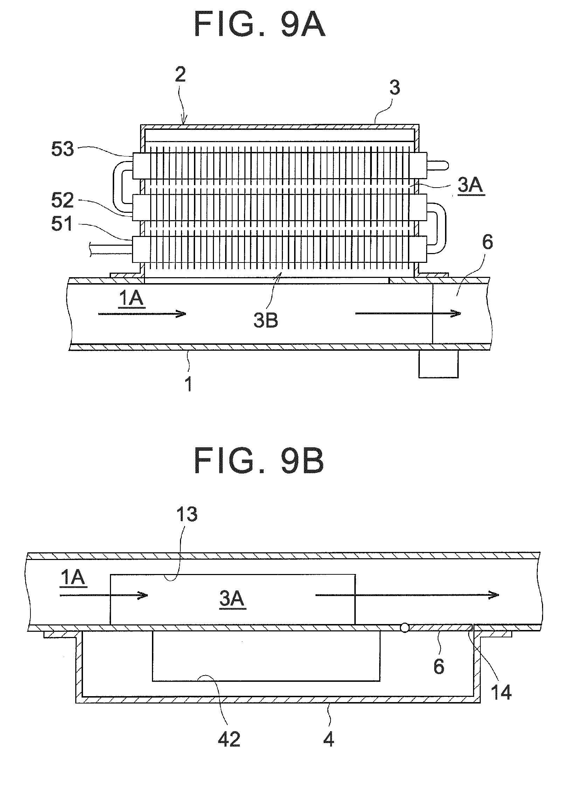

FIGS. 9A and 9B are views illustrating the flow of exhaust gas when the on-off valve 6 is in the fully open position. FIG. 9A is a view corresponding to FIG. 2, and FIG. 9B is a view corresponding to FIG. 4

When the on-off valve 6 is in the fully open position in this way, the opening 14 is closed, so exhaust gas that has flowed in from the upstream side of the exhaust passage 1A does not flow into the branch passage 3A, but instead flows directly toward the downstream side of the exhaust passage 1A and is discharged into the atmosphere (see the arrows in FIG. 9).

When exhaust gas is not allowed to flow into the branch passage 3A in this way, there is no request to the thermoelectric modules 51 to 56 to generate electricity, or the generation of electricity is prohibited, so coolant does not need to flow into the inner pipes of the thermoelectric modules 51 to 56. One example of a structure that does not allow coolant to flow into the inner pipe is one in which an electromagnetic valve is provided between the coolant circulation circuit and the inner pipe 51b of the first thermoelectric module 51, and this electromagnetic valve is closed. As a result, coolant is able to be prevented from flowing unnecessarily.

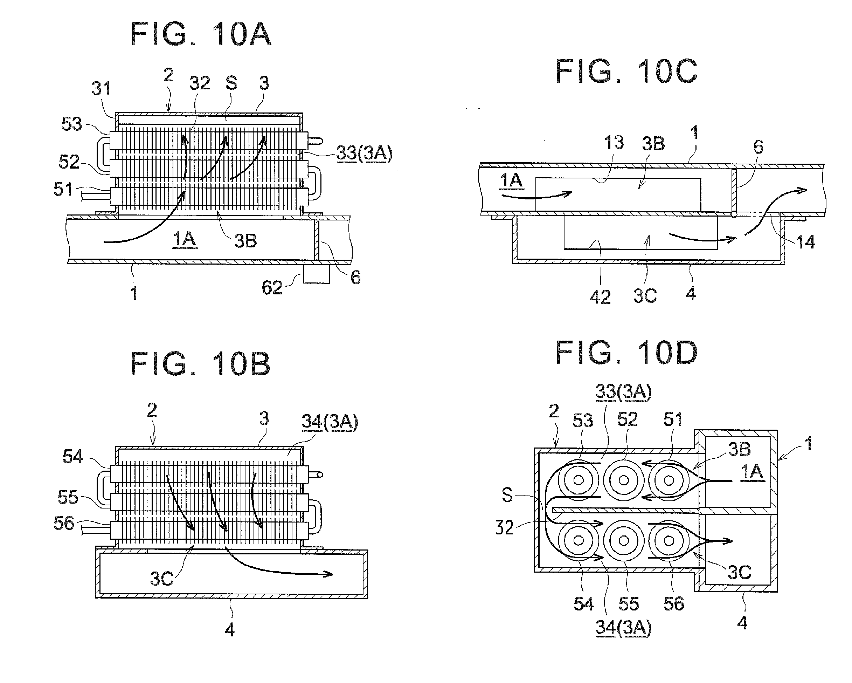

FIGS. 10A to 10D are views of the flow of exhaust gas when the on-off valve 6 is in the fully closed position. FIG. 10A is a view corresponding to FIG. 2, FIG. 10B is a view corresponding to FIG. 3, FIG 10C is a view corresponding to FIG 4, and FIG. 10D is a view corresponding to FIG. 6. When the on-off valve 6 is in the fully closed position, some of the coolant flowing through the coolant circulation circuit flows into the inner pipes of the thermoelectric modules 51 to 56.

When the on-off valve 6 is closed in this way, the opening 14 is open, so almost all of the exhaust gas that has flowed in from the upstream side of the exhaust passage 1A will flow into the branch passage 3A. In other words, the exhaust gas that has flowed in from the upstream side of the exhaust passage 1A flows through the inflow portion 3B and into the upper passage 33 in the casing 31, and then flows around the outer peripheries of the first thermoelectric module 51, the second thermoelectric module 52, and the third thermoelectric module 53 in this order, after which it passes through the communication path S (i.e., the communication path S that communicates the upper passage 33 with the lower passage 34). Upon passing through the communication path S, the flow of exhaust gas reverses, and the exhaust gas flows into the lower passage 34 in the casing 31. The exhaust gas that has flowed into the lower passage 34 then flows around the outer peripheries of the fourth thermoelectric module 54, the fifth thermoelectric module 55, and the sixth thermoelectric module 56 in this order, after which it flows into the return duct 4 through the outflow portion 3C (see the arrows in FIG. 10).

As a result of the exhaust gas flowing in this way, heat from the exhaust gas is imparted to the thermoelectric modules 51 to 56, and electromotive force corresponding to the temperature difference described above is generated in the thermoelectric modules 51 to 56 by the Seebeck effect.

After the exhaust gas that has flowed into the return duct 4 reaches the downstream end of the return duct 4, the flow direction changes upward, and the exhaust gas is returned to the exhaust passage 1A through the opening 14.

In this way, in this example embodiment, when exhaust gas flows to the branch passage 3A, almost all of the exhaust gas flows from the first thermoelectric module 51 to the sixth thermoelectric module 56 in this order. Therefore, a sufficient exhaust gas flow rate per thermoelectric module 51 to 56 is able to be obtained. As a result, a sufficient amount of waste heat is also able to be recovered, so the electric-generating capacity can be increased. That is, the flow rate of the exhaust gas that flows around the outer periphery of each thermoelectric module 51 to 56 is able to be kept high, so a sufficient exhaust gas mass flow rate is able to be obtained. Therefore, the boundary film heat resistance around the outer periphery of each thermoelectric module 51 to 56 is small, so a large amount of waste heat is able to be recovered, and consequently, the electric-generating capacity can be increased.

Here, the relationship between the flow rate of exhaust gas that flows around the outer peripheries of the thermoelectric modules 51 to 56, the mass flow rate of the exhaust gas, and the boundary film heat resistance, will be described.

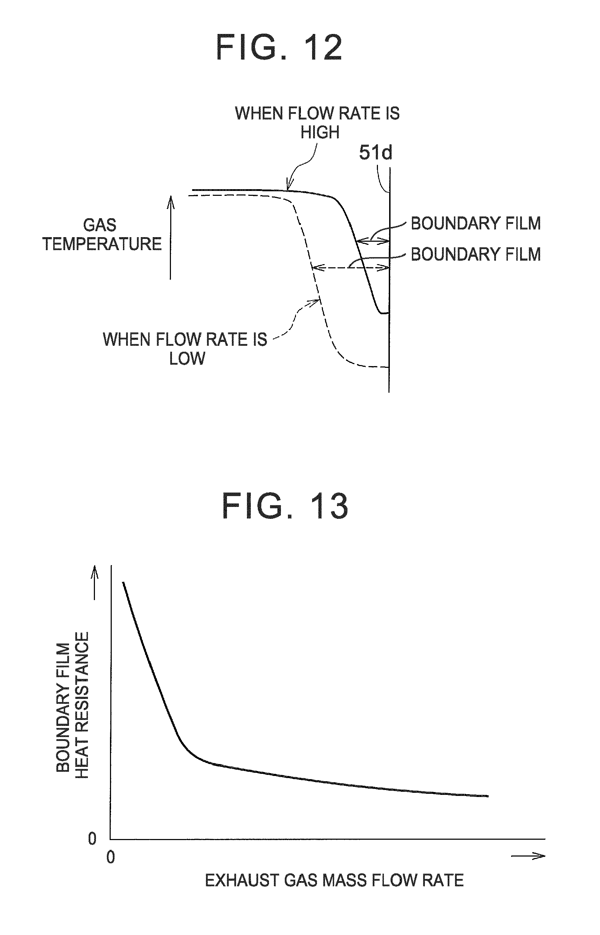

FIG. 12 is a view illustrating the relationship between the flow rate of exhaust gas that flows near the heat receiving fins 51d (only one heat receiving fin 51d is shown in the drawing) and the boundary film around the heat receiving fins 51d. In FIG. 12, the gas temperature indicated by the solid line indicates a temperature distribution around the heat receiving fins 51d when the flow rate of the exhaust gas is comparatively high. In FIG. 12, the gas temperature indicated by the broken line indicates a temperature distribution around the heat receiving fins 51d when the flow rate of the exhaust gas is comparatively low.

As is evident when referring to the boundary film indicated by the solid line (i.e., when the flow rate is high) and the boundary film indicated by the broken line (i.e., when the flow rate is low) in FIG. 12, the boundary film around the heat receiving fins 51d becomes thinner and the boundary film heat resistance becomes smaller as the flow rate of exhaust gas that flows near the heat receiving fins 51d increases and the mass flow rate of the exhaust gas becomes larger. Therefore, as the temperature distribution of exhaust gas that flows near the heat receiving fins 51d, the high temperature region is positioned closer to the heat receiving fins 51d, and the amount of heat imparted to the heat receiving fins 51d increases, as the flow rate of the exhaust gas increases. As a result, a large amount of waste heat is able to be recovered at the thermoelectric modules 51 to 56.

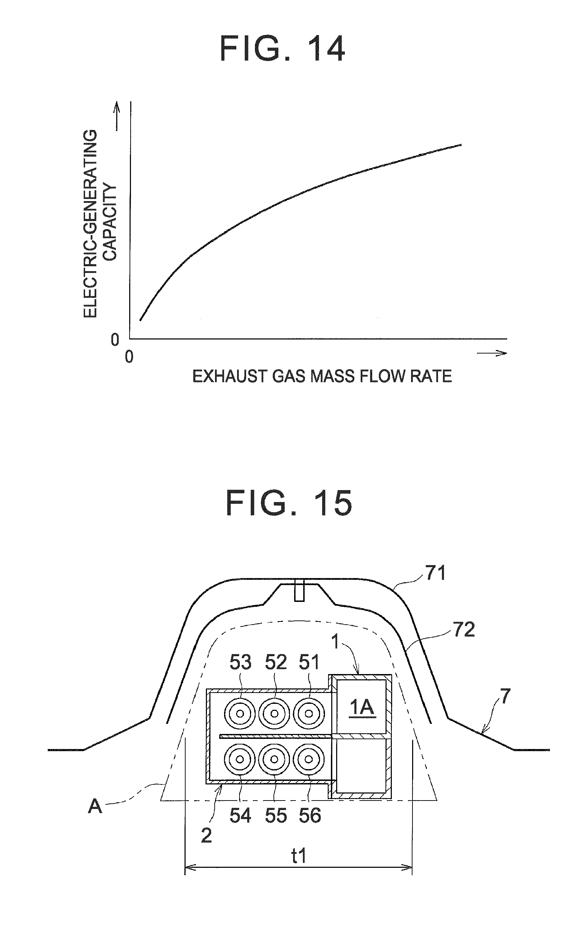

FIG. 13 is a view of the relationship between the mass flow rate of exhaust gas that flows around the thermoelectric modules, and the boundary film heat resistance around the heat receiving fins. FIG. 14 is a view of the relationship between the mass flow rate of exhaust gas that flows around the thermoelectric modules, and the electric-generating capacity of the thermoelectric modules.

As indicated in these drawings, the boundary film heat resistance around the heat receiving fins becomes smaller as the mass flow rate of the exhaust gas becomes larger, and the electric-generating capacity of the thermoelectric modules increases as the amount of waste heat that is recovered increases.

In this example embodiment, almost all of the exhaust gas that has flowed into the branch passage 3A flows from the first thermoelectric module 51 to the sixth thermoelectric module 56 in this order, as described above. As a result, a sufficient exhaust gas flow rate per thermoelectric module 51 to 56 is able to be obtained. That is, the mass flow rate of exhaust gas per thermoelectric module 51 to 56 is larger. Therefore, the boundary film heat resistance around the heat receiving fins 51d is smaller. As a result, the amount of waste heat recovered from the thermoelectric modules 51 to 56 increases, so the electric-generating capacity is able to be increased.

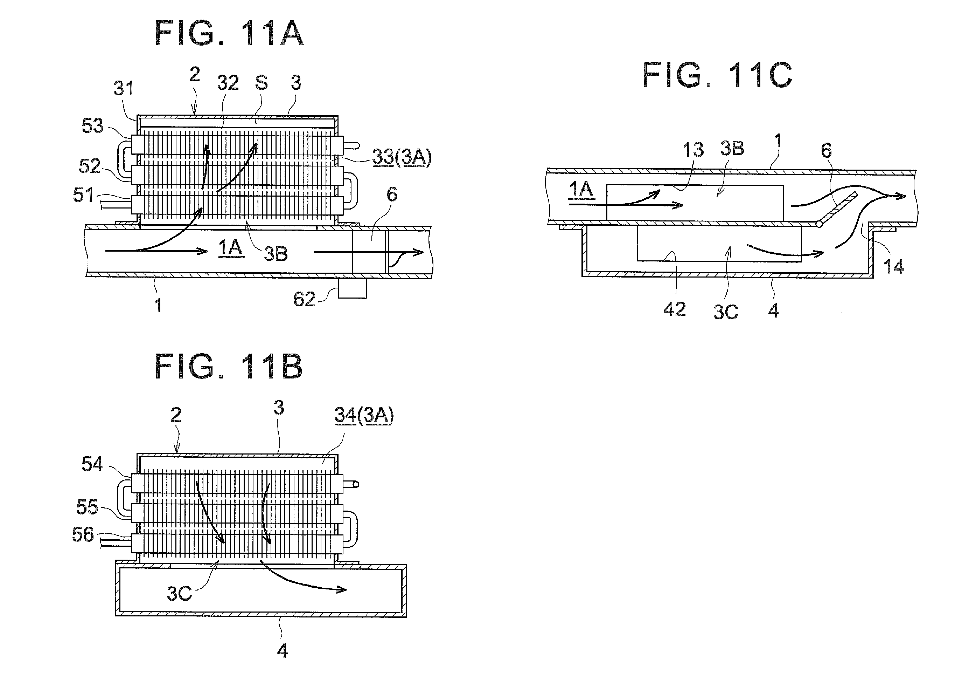

FIGS. 11A to 11C are views illustrating the flow of exhaust gas when the on-off valve 6 is in the partially open position. FIG. 11A is a view corresponding to FIG. 2, FIG. 11B is a view corresponding to FIG. 3, and FIG. 11C is a view corresponding to FIG. 4.

When the on-off valve 6 is in the partially open position in this way, the opening 14 is also partially open. Therefore, some of the exhaust gas that has flowed in from the upstream side of the exhaust passage 1A does not flow into the branch passage 3A, but instead flows directly toward the downstream side of the exhaust duct 1, while the rest of the exhaust gas flows into the branch passage 3A (see the arrows in FIG. 11).

Just as in the case described above, the exhaust gas that has flowed into the branch passage 3A flows from the upper passage 33 to the lower passage 34 inside the casing 31 and imparts heat to the thermoelectric modules 51 to 56, after which it flows into the return duct 4. Then, after the exhaust gas that has flowed into the return duct 4 reaches the downstream end of the return duct 4, the flow direction changes upward, and the exhaust gas is returned to the exhaust passage 1A through the opening 14. That is, it converges with the exhaust gas flowing through the exhaust passage 1A.

When the on-off valve 6 is partially open as well, the exhaust gas that has flowed into the apparatus main body 3 of the thermoelectric generator 2 flows from the first thermoelectric module 51 to the sixth thermoelectric module 56 in this order. Therefore, just as in the case described above, a sufficient amount of waste heat is able to be recovered, so the electric-generating capacity is able to be increased.

Next, the arrangement of the exhaust duct 1 and the thermoelectric generator 2 will be described. The exhaust duct 1 and the thermoelectric generator 2 are arranged below a floor panel 7 of a vehicle. More specifically, the exhaust duct 1 and the thermoelectric generator 2 are housed inside a tunnel portion 71 formed in the floor panel.

FIG. 15 is a view schematically showing the state in which the exhaust duct 1 and the thermoelectric generator 2 are arranged below the floor panel 7. As shown in FIG. 15, a heat insulator 72 is arranged between the tunnel portion 71 of the floor panel 7, and the exhaust duct 1 and the thermoelectric generator 2. The sectional shape of the heat insulator 72 substantially matches the sectional shape of the tunnel portion 71.

A predetermined distance is provided between the heat insulator 72,and the exhaust duct 1 and the thermoelectric generator 2, as well as between the exhaust duct 1 and the thermoelectric generator 2, and a road surface. This predetermined distance is set to a distance at which the exhaust duct 1 and the thermoelectric generator 2 will not contact either the heat insulator 72 or the road surface from jolting when the vehicle is running, for example. In order to ensure that the exhaust duct 1 and the thermoelectric generator 2 do not contact the heat insulator 72 or the road surface, the exhaust duct 1 and the thermoelectric generator 2 must be arranged within the area indicated by the chain double-dashed line in the drawing.

Therefore, as described in related art (US 2013/0186448 A, for example), in a structure in which a plurality of thermoelectric modules are arranged extending in a direction orthogonal to the direction in which an exhaust passage extends, the dimension in the length direction of the thermoelectric modules is limited to approximately the dimension t1 (e.g., 200 mm) in the drawing at most.

In this example embodiment, the length direction of the thermoelectric modules 51 to 56 is the same direction as the flow direction of exhaust gas in the exhaust passage 1A, so the length dimension of these is not restricted by the sectional shape of the tunnel portion 71. Therefore, the dimension in the length direction of the thermoelectric modules 51 to 56 can be set to approximately 500 mm, for example.

Next, opening control by the ECU 100 of the on-off valve 6 that changes the flow of exhaust gas as described above will be described.

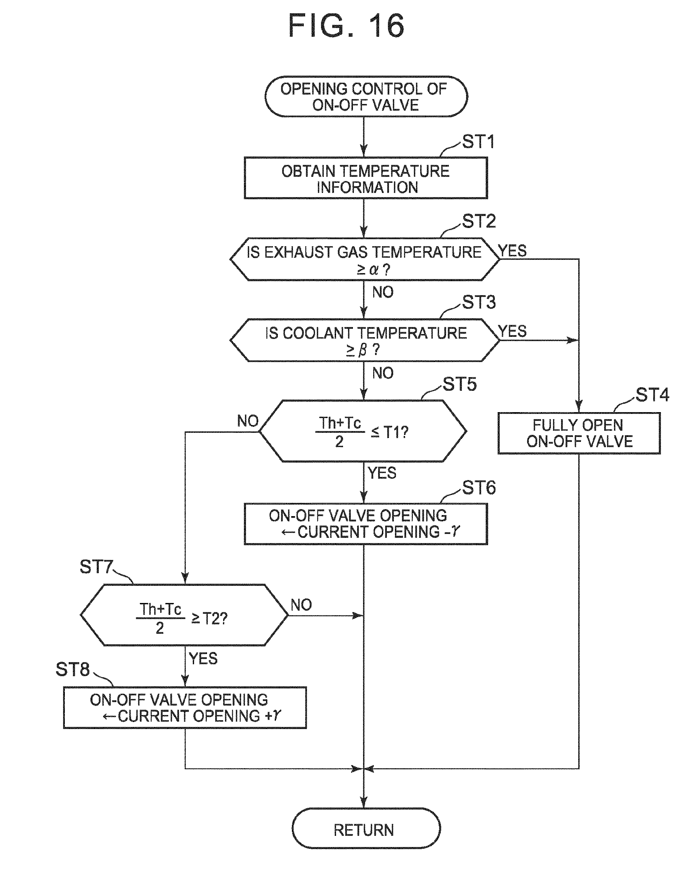

FIG. 16 is a flowchart illustrating a routine of the opening control of the on-off valve 6. The routine in this flowchart is executed at predetermined intervals of time (every several milliseconds) after the engine is started.

First, in step ST1, temperature information is obtained. More specifically, temperature information of the exhaust gas that flows through the exhaust passage 1A, and temperature information of the coolant that flows through the coolant circulation circuit, is obtained by the ECU 100.

The temperature information of the exhaust gas is obtained based on a signal from an exhaust gas temperature sensor provided in the exhaust duct 1. The mounting position of the exhaust gas temperature sensor is preferably near the mounting position of the exhaust duct 1 and the thermoelectric generator 2, and farther to the upstream side, in the flow direction of the exhaust gas, than the mounting position of the thermoelectric generator 2. The temperature information of the coolant is obtained based on a signal from a coolant temperature sensor provided in the coolant circulation circuit. The mounting position of the coolant temperature sensor is preferably near the branching position of the inner pipe 51b of the first thermoelectric module 51 in the coolant circulation circuit, and farther to the upstream side, in the flow direction of the coolant, than the branching position.

In step ST2, the ECU 100 determines whether the exhaust gas temperature is equal to or greater than a predetermined value α. The predetermined value α is set to a value obtained by multiplying a predetermined safety factor by an upper temperature limit of the thermoelectric conversion element, or a value obtained by subtracting a predetermined temperature from the upper temperature limit.

If the exhaust gas temperature is equal to or greater than the predetermined value α such that the determination in step ST2 is YES, the process proceeds on to step ST4 by the ECU 100 where the on-off valve 6 is controlled to be in the fully opened position because there is a possibility that if exhaust gas flows into the branch passage 3A at this time it may adversely affect (i.e., thermally damage) the thermoelectric conversion element, and then the process returns. That is, exhaust gas does not flow into the branch passage 3A (i.e., the exhaust gas bypasses the thermoelectric generator 2), and flows only into the exhaust passage 1A.

In this case, electric generation by the thermoelectric modules 51 to 56 is forcibly prohibited, so coolant is also stopped from flowing into the inner pipes of the thermoelectric modules 51 to 56. That is, in the structure described above, the electromagnetic valve provided between the coolant circulation circuit and the inner pipe 51b is closed. Coolant may also be made to flow into the inner pipes in order to protect the thermoelectric conversion elements from thermal damage, i.e., in order to protect the thermoelectric conversion elements from being thermally damaged by radiation from the exhaust gas.

If the exhaust gas temperature is less than the predetermined value α such that the determination in step ST2 is NO, the process proceeds on to step ST3 by the ECU 100. In step ST3 it is determined whether the coolant temperature is equal to or greater than a predetermined value β by the ECU 100. The predetermined value β is set to a value obtained by multiplying a predetermined safety factor by a temperature at which the engine overheats (e.g., 120°C), or a value obtained by subtracting a predetermined temperature from the temperature at which the engine overheats.

If the coolant temperature becomes equal to or greater than the predetermined value β such that the determination in step ST3 is YES, the ECU 100 determines that there is a possibility that the coolant temperature may become excessively high as a result of the coolant taking on heat from the thermoelectric modules 51 to 56 if coolant were made to flow into the thermoelectric modules 51 to 56 at this time, as a result, the engine may overheat, so the coolant temperature the on-off valve 6 is controlled to be in the fully opened position (step ST4), and then the process returns. That is, the exhaust gas bypasses the thermoelectric generator 2 and does not flow into the branch passage 3A, and only flows into the exhaust passage 1A. In this case, coolant is also stopped from flowing into the inner pipes of the thermoelectric modules 51 to 56.

If the coolant temperature is less than the predetermined value β such that the determination in step ST3 is NO, the process proceeds on to step ST5. In step ST5, the ECU 100 determines whether an average temperature (Th + Tc) / 2 of a temperature Th of the heat receiving board and a temperature Tc of the heat dissipating board is equal to or less than a predetermined temperature T1. The temperature Th of the heat receiving board and the temperature Tc of the heat dissipating board may be detected by temperature sensors, or the temperature Th of the heat receiving board may be estimated based on a signal from an exhaust gas temperature sensor arranged in the casing 31, and the temperature Tc of the heat dissipating board may be estimated based on a signal from a coolant temperature sensor arranged in the inner pipe 51b.

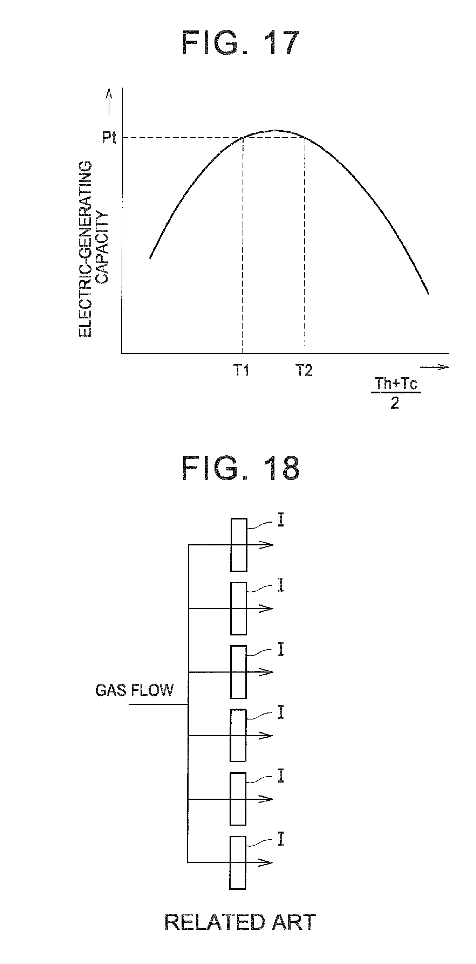

The average temperature of the temperature Th of the heat receiving board and the temperature Tc of the heat dissipating board is a value that correlates to the current electric-generating capacity of the thermoelectric modules 51 to 56. That is, in the thermoelectric conversion element, the electric-generating capacity differs according to the average temperature (Th + Tc) / 2. FIG. 17 is a view of one example of a relationship between the average temperature (Th + Tc) / 2 and the electric-generating capacity. As shown in FIG. 17, when the average temperature (Th + Tc) / 2 is between T1 and T2, the electric-generating capacity is equal to or greater than Pt in the drawing, so a sufficient electric-generating capacity can be obtained. The relationship between the average temperature (Th + Tc) / 2 and the electric-generating capacity differs depending on, for example, the material of the thermoelectric conversion element.

Therefore, when the current average temperature (Th + Tc) / 2 is equal to or less than a predetermined temperature T1 or equal to or greater than a predetermined temperature T2, a sufficient electric-generating capacity (i.e., electric-generating capacity Pt) may not be able to be obtained.

Step ST5 is a step for determining whether the current average temperature (Th + Tc) / 2 is equal to or less than the predetermined temperature T1 and a sufficient electric-generating capacity is unable to be obtained.

If the current average temperature (Th + Tc) / 2 is equal to or less than the predetermined temperature T1 such that the determination in step ST5 is YES, the process proceeds on to step ST6 by the ECU 100. In the step ST6, the opening of the on-off valve 6 is reduced from the current opening by a predetermined amount γ. That is, the on-off valve 6 is rotated by predetermined amount toward the closed side to increase the amount of exhaust gas that flows into the branch passage 3A. For example, the opening of the on-off valve 6 is reduced 5° to increase the amount of exhaust gas that flows into the branch passage 3A. As a result, the amount of heat imparted to the thermoelectric modules 51 to 56 is increased, so the average temperature (Th + Tc) / 2 increases, and consequently, the electric-generating capacity of the thermoelectric modules 51 to 56 increases.

On the other hand, if the current average temperature (Th + Tc) / 2 exceeds the predetermined temperature T1 such that the determination in step ST5 is NO, the process proceeds on to step ST7. In step ST7, the ECU 100 determines whether the average temperature (Th + Tc) / 2 is equal to or greater than a predetermined temperature T2. That is, the ECU determines whether the average temperature (Th + Tc) / 2 is so high that the electric-generating capacity Pt is unable to be obtained, as shown in FIG. 17.

If the current average temperature (Th + Tc) / 2 is equal to or greater than the predetermined temperature T2 such that the determination in step ST7 is YES, the process proceeds on to step ST8. In step ST8, the opening of the on-off valve 6 is increased from the current opening by a predetermined amount γ. That is, the on-off valve 6 is rotated a predetermined amount toward the open side to reduce the amount of exhaust gas that flows into the branch passage 3A. For example, the opening of the on-off valve 6 is increased 5° to reduce the amount of exhaust gas that flows into the branch passage 3A. As a result, the amount of heat imparted to the thermoelectric modules 51 to 56 is reduced, so the average temperature (Th + Tc) / 2 decreases, and consequently, the electric-generating capacity of the thermoelectric modules 51 to 56 increases.

If the current average temperature (Th + Tc) / 2 is less than the predetermined temperature T2 such that the determination in step ST7 is NO, the current opening of the on-off valve 6 is not changed, i.e., the amount of exhaust gas that flows into the branch passage 3A is not changed, and the process returns. That is, the current average temperature (Th + Tc) / 2 is between the predetermined temperatures T1 and T2, and the electric-generating capacity is exceeding Pt, so it is determined that the optimum opening of the on-off valve 6 is being obtained, and the process returns.

By repeating this kind of operation, a high electric-generating capacity is able to be obtained when both the temperature of the exhaust gas and the temperature of the coolant are within an allowable range.

As described above, according to this example embodiment, the thermoelectric modules 51 to 56 are arranged in series in the flow direction of the exhaust gas in the branch passage 3A (in the space in the casing 31). Therefore, almost all of the exhaust gas that flows through the branch passage 3A flows around the outer peripheries of the thermoelectric modules 51 to 56 in this order. That is, almost all of the exhaust gas imparts heat to the thermoelectric modules 51 to 56 in this order. Therefore, a sufficient exhaust gas flow rate per thermoelectric module 51 to 56 is able to be obtained. That is, a sufficient exhaust gas flow rate per thermoelectric module is able to be obtained compared to the related art in which exhaust gas is divided and flows separately to each thermoelectric module. As a result, a sufficient amount of waste heat is able to be recovered. That is, the flow rate of the exhaust gas that flows along the outer periphery of each thermoelectric module 51 to 56 is able to be kept high, so the mass flow rate of the exhaust gas increases. As a result, the boundary film heat resistance around the outer peripheries of the thermoelectric modules 51 to 56 is smaller, so the amount of waste heat that is recovered can be increased, and consequently, the electric-generating capacity can be increased.

The thermoelectric modules 51 to 56 are arranged in the branch passage 3A in such a manner that the length direction of the thermoelectric modules 51 to 56 is the same direction as the flow direction of the exhaust gas in the exhaust passage 1A. Therefore, the length dimension of the thermoelectric modules 51 to 56 tends not to be restricted by the width dimension of the tunnel portion 71 and can be set comparatively long. That is, the length dimension of the thermoelectric modules can be set relatively long compared to the related art in which the length direction of the thermoelectric modules is set to a direction orthogonal to the flow direction of the exhaust gas in the exhaust passage. Therefore, the amount of waste heat recovered per thermoelectric module 51 to 56 can be increased, so the amount of waste heat that is recovered for the entire thermoelectric generator 2 can also be increased, and thus the electric-generating capacity can be increased.

The upper passage 33 and the lower passage 34 that form the branch passage 3A are adjacent to each other with the partition 32 therebetween. Therefore, the lower side of the upper passage 33 and the upper side of the lower passage 34 are not exposed to outside air, so almost no heat from these portions is lost to outside air. Therefore, the amount of decrease in the exhaust gas temperature caused by heat loss to outside air is reduced. That is, the amount of decrease in the exhaust gas temperature due to heat loss to outside air is less than it is with a structure in which the entire surface of the outer surface of the thermoelectric generator is exposed to outside air, as is the case with JP 2004-360681 A (JP 2004-360681 A), for example. Therefore, the temperature of the exhaust gas that flows through the spaces 33 and 34 is able to be kept high. As a result, the amount of heat imparted to the thermoelectric modules 51 to 56 increases, so the amount of waste heat that is recovered is able to be increased, and thus the electric-generating capacity is able to be increased.

Having the exhaust duct 1 and the thermoelectric generator 2 be an integrated structure enables the size of the space within which they are arranged to be smaller.

In this example embodiment, the casing 31 has a rectangular cross-section (i.e., the cross-section in a direction orthogonal to the Z direction is a rectangular cross-section), which enables the height dimension of the thermoelectric generator 2 to be set shorter than it is with a circular cross-section. That is, when the sectional area of the casing 31 is the same, geometrically the height dimension is able to be set approximately 12% shorter than it is with a casing having a circular cross-section. Therefore, mountability in a vehicle is good.

In addition, the amount of heat received by the thermoelectric modules 51 to 56 is larger as described above, so the amount of heat transferred to other members such as the casing 31 is able to be reduced by that amount. Thus, the amount of heat expansion of these members is able to be suppressed, so the durability of these members is able to be improved.

Next, a test example performed to confirm the effects of the example embodiment, as well as the results of the test example, will be described.

FIG. 18 is a view showing a frame format of an arrangement of thermoelectric modules I in related art (the contributed article in the September 2013 issue of Automobiltechnische Zeitschrift (ATZ), pp 714 to 719), and the flow of exhaust gas that flows around these thermoelectric modules I, as a comparative example. That is, the structure is such that exhaust gas is divided and split off to each thermoelectric module I, and each flow of the divided exhaust gas flows separately along the outer peripheral surface of a corresponding thermoelectric module I (hereinafter, this will be referred to as a "parallel configuration").

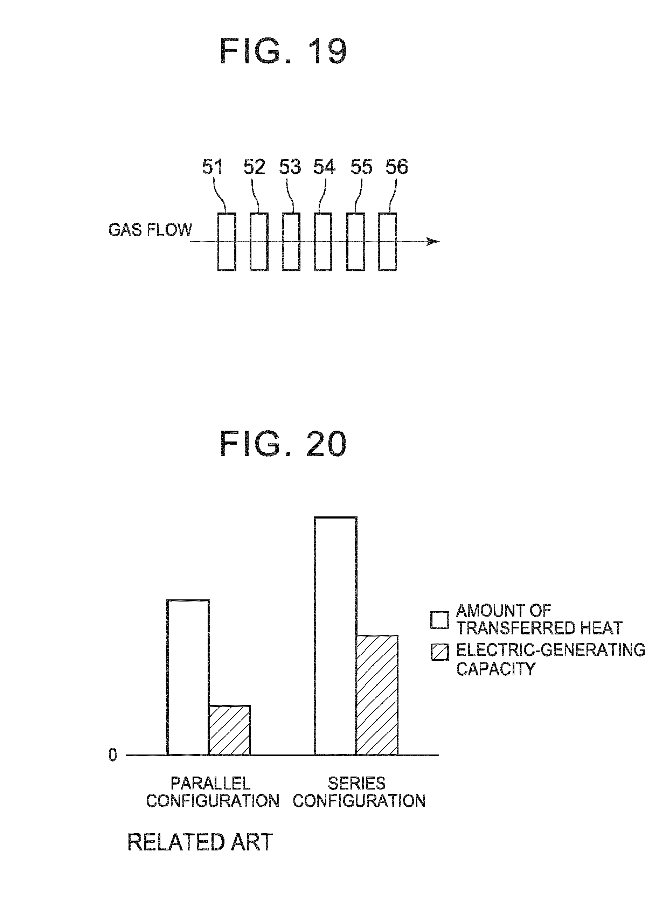

On the other hand, FIG. 19 is a view showing a frame format of the arrangement of the thermoelectric modules 51 to 56 in the example embodiment described above, and the flow of exhaust gas that flows around these thermoelectric modules 51 to 56. That is, the structure is such that exhaust gas flows around the outer periphery of each thermoelectric module 51 to 56 in order (hereinafter, this will be referred to as a "series configuration").

In the test, exhaust gas at the same temperature and flow rate is flowed through the parallel configuration and the series configuration, and the amount of heat transferred and the electric-generating capacity of each is measured and the results are compared.

FIG. 20 is a view of the measurement results of the amount of heat transferred to thermoelectric modules (i.e., the amount of heat transferred to six thermoelectric modules) and the electric-generating capacity of the thermoelectric modules (the electric-generating capacity of six thermoelectric modules) in both configurations (i.e., the parallel configuration as the comparative example, and the series configuration as the structure of the example embodiment). As is evident from FIG. 20, the amount of transferred heat and the electric-generating capacity are both substantially higher with the series configuration than they are with the parallel configuration. For example, the amount of transferred heat in the series configuration is approximately 1.5 times the amount of transferred heat in the parallel configuration. Also, the electric-generating capacity in the series configuration is approximately 2.3 times the electric-generating capacity in the parallel configuration. Thus, the effects of the example embodiment are confirmed.

Next, a second example embodiment of the invention will be described.

In this example embodiment, the structure of the casing 31 of the apparatus main body 3 differs from that in the first example embodiment described above. Therefore, only the differences from the first example embodiment will be described here.

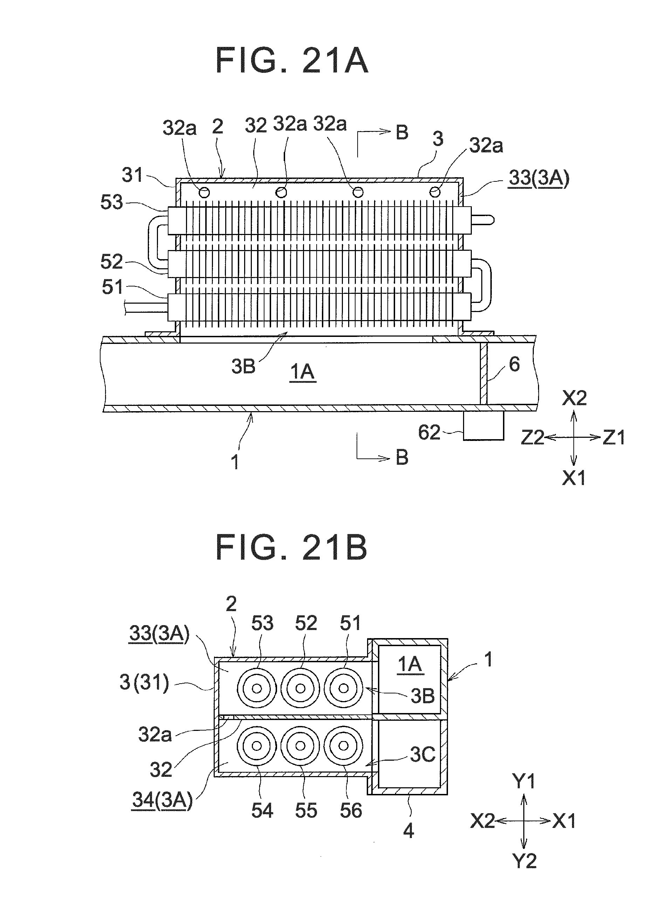

FIGS. 21A and 21B are views of the thermoelectric generator 2 according to this example embodiment. FIG. 21A is a view corresponding to FIG. 2, and FIG. 21B is a view corresponding to FIG. 6 (FIG. 21B is a sectional view in a position corresponding to line B - B in FIG. 21A).

As shown in FIGS. 21A and 21B, the partition 32 of the thermoelectric generator 2 according to this example embodiment is such that end edges thereof that are positioned on the X1 direction side and the X2 direction side, respectively, are each connected to an inside surface of the casing 31.

A plurality of communication holes 32a that pass through (in the Y direction) the partition 32 are formed in four locations near the end edge provided on the X2 direction side of the partition 32. Therefore, the upper passage 33 and the lower passage 34 inside of the casing 31 that are partitioned by the partition 32 are communicated by only these communication holes 32a.

The flow of exhaust gas in the branch passage 3A in this example embodiment is such that exhaust gas that has flowed through the upper passage 33 and around the outer peripheries of the first thermoelectric module 51, the second thermoelectric module 52, and the third thermoelectric module 53 in this order, flows through the communication holes 32a and into the lower passage 34. Then, the exhaust gas that has flowed into this lower passage 34 flows around the outer peripheries of the fourth thermoelectric module 54, the fifth thermoelectric module 55, and the sixth thermoelectric module 56 in this order.

The other structure and the operation for generating electricity and the like are the same as they are in the first example embodiment.

According to this example embodiment, the number, hole diameter, and arrangement positions of the communication holes 32a can be set as appropriate, and the flows of exhaust gas in the upper passage 33 and the lower passage 34 can be regulated by these settings. Therefore, the degree of freedom in design related to regulation of the flow of the exhaust gas is able to be improved.

Next, a third example embodiment of the invention will be described.

The example embodiment differs from the first example embodiment regarding the arrangement of the plurality of thermoelectric modules 51 to 56 that are arranged in the branch passage 3A. Therefore, only the differences from the first example embodiment will be described here as well.

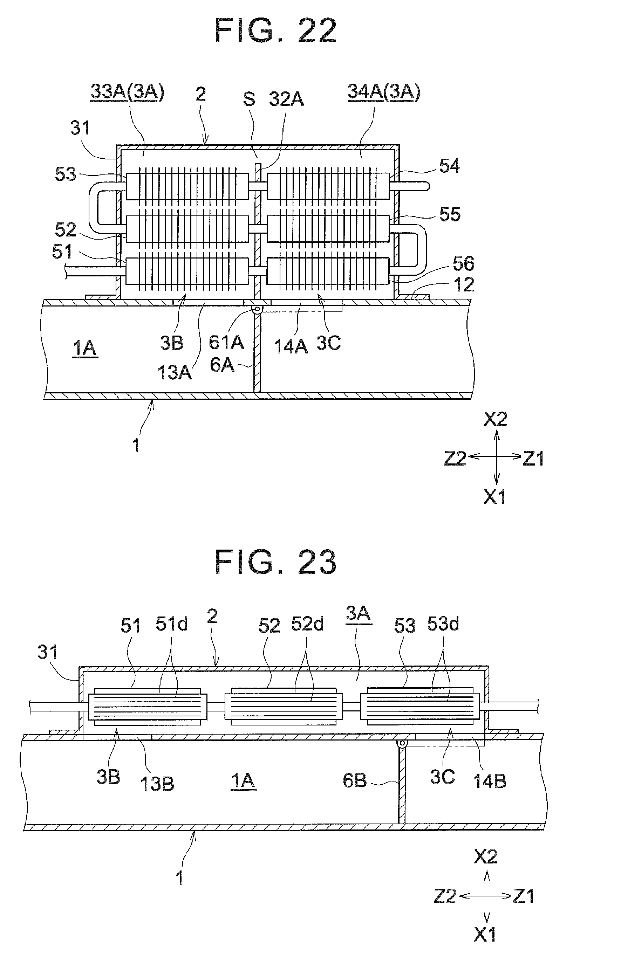

FIG. 22 is a view corresponds to FIG. 2, of the thermoelectric generator 2 according to this example embodiment.

As shown in FIG. 22, in the thermoelectric generator 2 according to this example embodiment, a partition 32A that partitions the internal space of the casing 31 front and back (a Z1 direction side and a Z2 direction side) is provided in a generally center portion in the front-back direction (Z direction) of the casing 31. An end edge of this partition 32A that is positioned on the X2 direction side is positioned a predetermined distance from the inside surface (i.e., the inside surface positioned on the X2 direction side) of the casing 31. Also, the other end edge of the partition 32A is connected to the inside surface of the casing 31. Therefore, a front passage 33A and a rear passage 34A inside the casing 31 that are partitioned by this partition 32A are communicated by only a communication path S formed between the end edge of the partition 32A positioned on the X2 direction side and the inside surface of the casing 31.

The X1 direction side of the casing 31 is open. Openings 13A and 14A are formed in the exhaust duct 1 in positions corresponding to the front passage 33A and the rear passage 34A, respectively. Thus, an inflow portion 3B is formed by the open portion of the casing 31 and the opening 13A, and an outflow portion 3C is formed by the open portion of the casing 31 and the opening 14A.

Three thermoelectric modules 51, 52, and 53 are housed in the front passage 33A. These thermoelectric modules 51, 52, and 53 are arranged with their axes extending in the Z direction and are lined up in order in the X direction. Similarly, three thermoelectric modules 54, 55, and 56 are also housed in the rear passage 34A. These thermoelectric modules 54, 55, and 56 are also arranged with their axes extending in the Z direction, and are lined up in order in the X direction. In this example embodiment, the inside of the casing 31 is not partitioned vertically (in the Y direction), and all of the thermoelectric modules 51 to 56 are arranged on the same plane.

In this way, the thermoelectric modules 51 to 56 are arranged in the branch passage 3A in such a manner that the length direction of the thermoelectric modules 51 to 56 is the same direction as the flow direction of the exhaust gas in the exhaust passage 1A (i.e., the length direction of the exhaust duct 1). These thermoelectric modules 51 to 56 are arranged in series in the exhaust gas flow direction from the inflow portion 3B toward the outflow portion 3C.

An on-off valve 6A is provided between the openings 13A and 14A in the exhaust duct 1. This on-off valve 6A has a rectangular shape that substantially matches the sectional shape of the exhaust duct 1, and is supported by a rotating shaft 61A that is arranged on a side surface of the exhaust duct 1 and extends in the Y direction. Also, the rotating shaft 61A of this on-off valve 6A is connected to an electric motor, not shown. The opening of the on-off valve 6A is able to be adjusted by the operation of this electric motor. More specifically, the on-off valve 6A is able to be adjusted between a fully closed position indicated by the solid line in FIG. 22 (a position that results in the exhaust passage 1A being in a closed state), and a fully open position indicated by the virtual line in FIG. 22 (a position that results in the exhaust passage 1A being in a open state).

When the on-off valve 6A is in the fully closed position indicated by the solid line in FIG. 22, the exhaust passage 1A is closed, so exhaust gas that has flowed in from the upstream side of the exhaust passage 1A flows from the inflow portion 3B into the front passage 33A of the casing 31. Then, the exhaust gas flows through the communication path S and the rear passage 34A, and is discharged into the exhaust passage 1A from the outflow portion 3C. Also, when the on-off valve 6A is in the fully open position indicated by the virtual line in FIG. 22, the exhaust passage 1A is open, so exhaust gas that has flowed in from the upstream side of the exhaust passage 1A does not flow into the branch passage 3A, but instead flows directly toward the downstream side of the exhaust passage 1A. Further, when the on-off valve 6A is set to a partially open position between the fully closed positon and the fully open position, the ratio of the amount of exhaust gas that flows into the branch passage 3A and the amount of exhaust gas that flows through the exhaust passage 1A without flowing into the branch passage 3A (i.e., the amount of exhaust gas that bypasses the thermoelectric generator 2) is able to be adjusted according to that position.

The other structure and the operation for generating electricity and the like are the same as they are in the first example embodiment.

In this example embodiment, when the on-off valve 6A is in the fully closed position or the partially open position, exhaust gas that flows through the exhaust passage 1A flows into the branch passage 3A. When the exhaust gas that has flowed into the branch passage 3A flows from the front passage 33A to the rear passage 34A, this exhaust gas flows from the first thermoelectric module 51 to the sixth thermoelectric module 56 in this order, and imparts heat to the thermoelectric modules 51 to 56. Therefore, a sufficient exhaust gas flow rate per thermoelectric module 51 to 56 is able to be obtained, so a sufficient amount of waste heat is also able to be recovered, and thus the electric-generating capacity is able to be increased.

Next, a fourth example embodiment of the invention will be described.

This example embodiment also differs from the first example embodiment described above in terms of the arrangement of the plurality of thermoelectric modules that are arranged in the branch passage 3A. Therefore, only the differences from the first example embodiment will be described here as well.

FIG. 23 is a view corresponding to FIG. 2, of the thermoelectric generator 2 according to this example embodiment.

As shown in FIG. 23, in the thermoelectric generator 2 according to this example embodiment, the X1 direction side of the casing 31 is open, and a front opening 13B is formed in the exhaust duct 1, in a position corresponding to an area near an end portion on one side (the Z2 direction side) in the length direction of the casing 31, and a rear opening 14B is formed in the exhaust duct 1, in a position corresponding to an area near an end portion on the other side (the Z1 direction side) in the length direction of the casing 31. Therefore, the inflow portion 3B is formed by the open portion of the casing 31 and the front opening 13B, and the outflow portion 3C is formed by the open portion of the casing 31 and the rear opening 14B. In this structure, a portion of the exhaust duct 1 corresponds to a wall that forms the branch passage 3A and faces the exhaust passage 1A.

Three thermoelectric modules 51, 52, and 53 are housed in the internal space of the casing 31. These thermoelectric modules 51, 52, and 53 are arranged with their axes extending in the Z direction (the length direction of the exhaust passage 1A) and are lined up in order in the Z direction. That is, the central axes of the thermoelectric modules 51, 52, and 53 are all arranged on the same straight line.

Heat receiving fins 51d, 52d, and 53d integrally formed on the outer peripheral surfaces of these thermoelectric modules 51, 52, and 53 extend in a direction following the axes of the thermoelectric modules 51, 52, and 53. The heat receiving fins 51d, 52d, and 53d are arranged with a predetermined pitch in the circumferential direction of the thermoelectric modules 51, 52, and 53. In this way, the extending direction of the heat receiving fins 51d, 52d, and 53d is set to be a direction (the Z direction) that substantially follows the flow direction of exhaust gas in the branch passage 3A. In this way, in this example embodiment, the thermoelectric modules 51, 52, and 53 are arranged in the branch passage 3A in such a manner that the length direction of the thermoelectric modules 51, 52, and 53 is the same direction as the flow direction of exhaust gas in the exhaust passage 1A, and these thermoelectric modules 51, 52, and 53 are arranged in series in the flow direction of exhaust gas that flows from the inflow portion 3B toward the outflow portion 3C.

Also, an on-off valve 6B is provided between the openings 13B and 14B of the exhaust duct 1. The structure of this on-off valve 6B is the same as that in the third example embodiment so a description thereof will be omitted here.

The other structure and the operation for generating electricity and the like are the same as they are in the first example embodiment.

In this example embodiment, when the on-off valve 6B is in the fully closed position or the partially open position, exhaust gas that has flowed through the exhaust passage 1A flows into the branch passage 3A. When the exhaust gas that has flowed into the branch passage 3A flows through the branch passage 3A, the exhaust gas flows from the first thermoelectric module 51 to the third thermoelectric module 53 in this order, and imparts heat to the thermoelectric modules 51, 52, and 53. Therefore, a sufficient exhaust gas flow rate per thermoelectric module 51, 52, and 53 is able to be obtained, so a sufficient amount of waste heat is also able to be recovered, and thus the electric-generating capacity is able to be increased.

Next, a fifth example embodiment of the invention will be described.

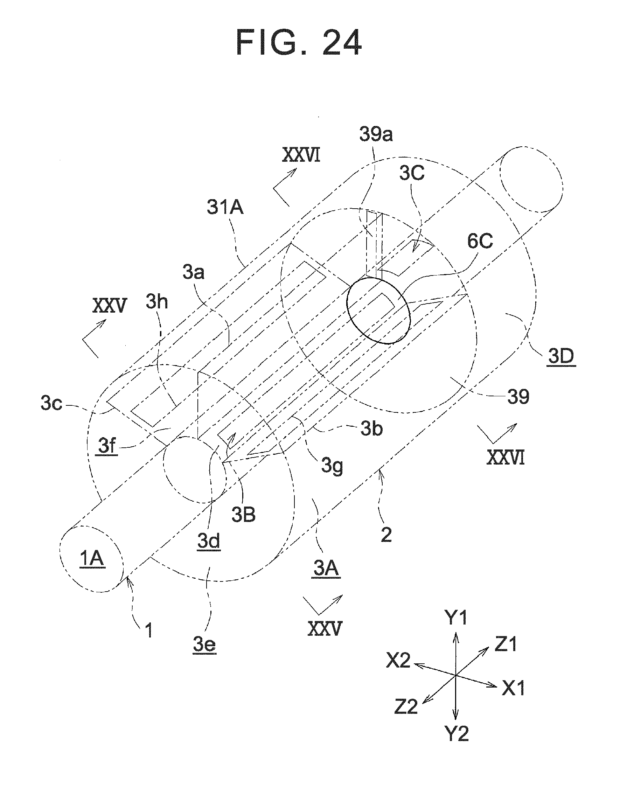

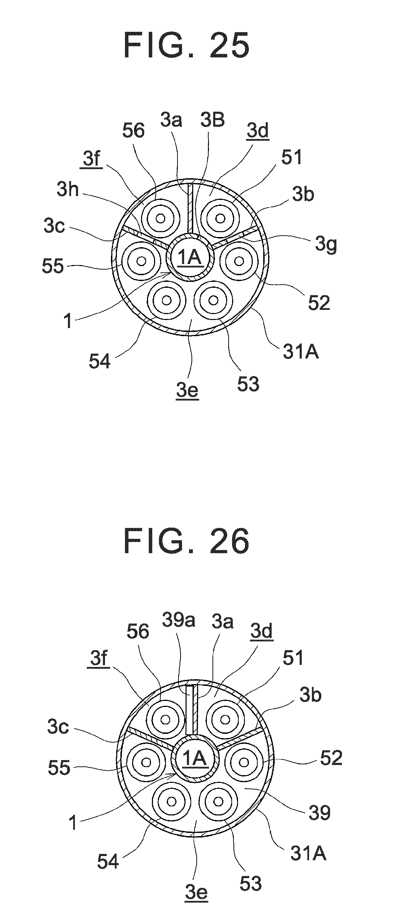

FIG. 24 is a block diagram schematically showing the exhaust duct 1 and the thermoelectric generator 2 of this example embodiment. In the drawing, the thermoelectric modules are omitted, an on-off valve 6C is indicated by a solid line, and the other members are indicated by virtual lines. Also, FIG. 25 is a sectional view of a position corresponding to line XXV - XXV in FIG. 24, and FIG. 26 is a sectional view of a position corresponding to line XXVI - XXVI in FIG. 24.

As shown in these drawings, the thermoelectric generator 2 according to this example embodiment is arranged surrounding the outer periphery of the exhaust duct 1. That is, a casing 31A having an outer diameter that is larger by a predetermined dimension than the outer diameter of the exhaust duct 1 is provided, and a space that forms the branch passage 3A is formed between the outer surface of the exhaust duct 1 and the inner surface of the casing 31A. That is, the branch passage 3A is arranged as a space that covers the outer periphery of a portion of the exhaust passage 1A (a portion in the length direction of the exhaust passage 1A) along the entire circumferential direction thereof. An entire wall on the exhaust passage 1A side of this branch passage 3A is not exposed to outside air and faces the exhaust passage 1A.

As show in FIGS. 24 and 25, an inflow portion 3B and an outflow portion 3C are arranged on an outer peripheral surface of the exhaust duct 1. The inflow portion 3B is an opening that is positioned on the upstream side (the Z2 direction side), in the flow direction of exhaust gas, in the outer peripheral surface of the exhaust duct 1, and through which exhaust gas flows from the exhaust passage 1A into the branch passage 3A. The outflow portion 3C is an opening that is positioned on the downstream side (the Z1 direction side), in the flow direction of exhaust gas, of the inflow portion 3B in the outer peripheral surface of the exhaust duct 1, and through which exhaust gas flows out to the exhaust passage 1A.

Also, as shown in FIG. 26, a partition 39 that partitions the internal space of the casing 31A into a Z2 direction side and a Z1 direction side is provided inside of the casing 31A. The position where this partition 39 is arranged is set between the inflow portion 3B and the outflow portion 3C in the Z direction. Therefore, the space on the front side (i.e., the Z2 direction side), of the internal space of the casing 31A that is partitioned by the partition 39, is formed as a branch passage 3A, and the space on the rear side (i.e., the Z1 direction side) is formed as a return passage 3D.

Also, six thermoelectric modules 51 to 56 are arranged in order in the circumferential direction of the branch passage 3A, in the branch passage 3A.

Three partition walls 3a, 3b, and 3c that extend in the radial direction are provided between the outside surface of the exhaust duct 1 and the inside surface of the casing 31A, in the branch passage 3A. A space (i.e., the branch passage 3A) between the outside surface of the exhaust duct 1 and the inside surface of the casing 31A is partitioned into three spaces 3d, 3e, and 3f in the circumferential direction, by these partition walls 3a, 3b, and 3c. As shown in FIGS. 25 and 26, the first partition wall 3a is positioned between the first thermoelectric module 51 and the sixth thermoelectric module 56. The second partition wall 3b is positioned between the first thermoelectric module 51 and the second thermoelectric module 52. Therefore, the first thermoelectric module 51 is arranged in a space enclosed between the first partition wall 3a and the second partition wall 3b. Hereinafter, this space will be referred to as the "first space 3d". The inflow portion 3B is open to this first space 3d.

The third partition wall 3c is positioned between the fifth thermoelectric module 55 and the sixth thermoelectric module 56. Therefore, the second thermoelectric module 52, the third thermoelectric module 53, the fourth thermoelectric module 54, and the fifth thermoelectric module 55 are arranged in order in the circumferential direction, in a space enclosed between the second partition wall 3b and the third partition wall 3c. Hereinafter, this space will be referred to as the "second space 3e".

Also, the sixth thermoelectric module 56 is arranged in a space enclosed between the third partition wall 3c and the first partition wall 3a. Hereinafter, this space will be referred to as the "third space 3f".

Openings 3g and 3h are formed in the second partition wall 3b and the third partition wall 3c, respectively. Therefore, after exhaust gas that has flowed from the exhaust passage 1A into the first space 3d through the inflow portion 3B flows around the outer periphery of the first thermoelectric module 51, this exhaust gas then flows into the second space 3e through the opening 3g in the second partition wall 3b. Consequently, the exhaust gas flows in order from around the outer periphery of the second thermoelectric module 52 to around the outer periphery of the fifth thermoelectric module 55, and then flows into the third space 3f through the opening 3h in the third partition wall 3c. As a result, the exhaust gas flows around the outer periphery of the sixth thermoelectric module 56.

An opening 39a that communicates the branch passage 3A with the return passage 3D is formed in the partition 39. This opening 39a is between a position where the first partition wall 3a is connected to the partition 39 and a position where the third partition wall 3c is connected to the partition 39. That is, the opening 39a faces the third space 3f.

An on-off valve 6C is provided in the exhaust duct 1. The position where the on-off valve 6C is arranged is set between the inflow portion 3B and the outflow portion 3C in the Z direction.

Therefore, when the on-off valve 6C is in a fully closed position, the exhaust passage 1A is closed, so the exhaust gas that has flowed in from the upstream side of the exhaust passage 1A flows from the inflow portion 3B into the branch passage 3A. Then, while passing through the openings 3g and 3h in the second partition wall 3b and the third partition wall 3c, respectively, the exhaust gas flows in order from around the outer periphery of the first thermoelectric module 51 to around the outer periphery of the sixth thermoelectric module 56, as described above. After this, the exhaust gas flows through the opening 39a in the partition 39 and into the return passage 3D, and is returned to the exhaust passage 1A from the outflow portion 3C.

When the on-off valve 6C is in an open state, most of the exhaust gas that has flowed in from upstream of the exhaust passage 1A flows directly toward the downstream side of the exhaust passage 1A, without flowing into the branch passage 3A.

When the on-off valve 6C is in a partially open state, the ratio of the amount of exhaust gas that flows into the branch passage 3A and the amount of exhaust gas that flows through the exhaust passage 1A without flowing into the branch passage 3A (i.e., the amount of exhaust gas that bypasses the thermoelectric generator 2) is able to be adjusted according to the position of the on-off valve 6C.

The other structure and the operation for generating electricity and the like are the same as they are in the first example embodiment.

With the structure of this example embodiment as well, a sufficient exhaust gas flow rate per thermoelectric module 51 to 56 is able to be obtained, so a sufficient amount of waste heat is able to be recovered, and thus the electric-generating capacity is able to be increased.

Next, a sixth example embodiment of the invention will be described.

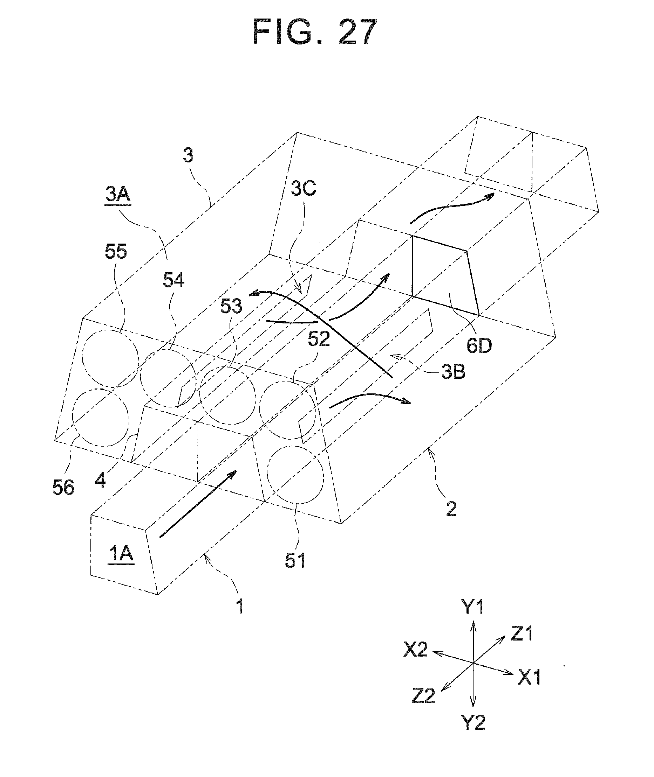

FIG. 27 is a block diagram schematically showing an exhaust duct 1 and a thermoelectric generator 2 of this example embodiment. An on-off valve 6D is indicated by a solid line, and the other members are indicated by virtual lines.

The thermoelectric generator 2 according to this example embodiment includes an apparatus main body 3, and a return duct 4 for returning exhaust gas that has flowed out from this apparatus main body 3 to the exhaust passage 1A, similar to that in the first example embodiment described above. The return duct 4 is connected on the X2 direction side to the exhaust duct 1. Also, the apparatus main body 3 has a cross-section (a cross-section in a direction orthogonal to the Z direction) formed in a trapezoidal shape, and covers upper surfaces (i.e., surfaces positioned on the Y1 direction side) of the exhaust duct 1 and the return duct 4, a side surface (a surface positioned on the X1 direction side) of the exhaust duct 1, and a side surface (a surface positioned on the X2 direction side) of the return duct 4.

An opening that becomes an inflow portion 3B through which exhaust gas flows into a branch passage (an internal space of the apparatus main body 3) 3A from the exhaust passage 1A, is formed in a side surface on the X1 direction side of the exhaust duct 1. Also, an opening that becomes an outflow portion 3C through which exhaust gas flows from the branch passage 3A toward the exhaust passage 1A is formed in a side surface on the X2 direction side of the return duct 4.

Six thermoelectric modules 51 to 56 are arranged in order in the flow direction of exhaust gas in the branch passage 3A, in the branch passage 3A (in FIG. 27, only the positions of end surfaces (end surfaces on the Z2 direction side) of the thermoelectric modules 51 to 56 are shown).

An on-off valve 6D is provided in the exhaust duct 1. The position where this on-off valve 6D is arranged is farther downstream, in the flow direction of exhaust gas (i.e., the flow direction of exhaust gas in the exhaust passage 1A), than the position of the inflow portion 3B.

Therefore, when the on-off valve 6D is in the fully closed position (i.e., the state indicated by the solid line in FIG. 27), the exhaust passage 1A is closed, so exhaust gas that has flowed in from the upstream side of the exhaust passage 1A flows from the inflow portion 3B into the branch passage 3A. The exhaust gas that has flowed into the branch passage 3A then flows in order from around the outer periphery of the first thermoelectric module 51 to around the outer periphery of the sixth thermoelectric module 56. Then, the exhaust gas flows through the outflow portion 3C and the return duct 4, after which it is returned to the exhaust passage 1A (see the arrows in FIG. 27).

When the on-off valve 6D is in the open state (i.e., the state indicated by the virtual line in FIG. 27), the exhaust gas that has flowed in from the upstream side of the exhaust passage 1A flows directly toward the downstream side of the exhaust passage 1A, without flowing into the branch passage 3A.

When the on-off valve 6D is in the partially open state, the ratio of the amount of exhaust gas that flows into the branch passage 3A and the amount of exhaust gas that flows through the exhaust passage 1A without flowing into the branch passage 3A (i.e., the amount of exhaust gas that bypasses the thermoelectric generator 2) is able to be adjusted according to that opening.

The other structure and the operation for generating electricity and the like are the same as they are in the first example embodiment.

With the structure of this example embodiment as well, a sufficient exhaust gas flow rate per thermoelectric module 51 to 56 is able to be obtained, so a sufficient amount of waste heat is able to be recovered, and thus the electric-generating capacity is able to be increased.

In the structure of this example embodiment, the cross-section (the cross-section in a direction orthogonal to the Z direction) of the apparatus main body 3 has a trapezoidal shape, and is thus able to substantially match the shape of the area indicated by the chain double-dashed line in FIG. 15 (i.e., the shape of a mounting space that is limited so that the exhaust duct 1 and the thermoelectric generator 2 will not contact the heat insulator 72 or the road surface). As a result, a large thermoelectric generator 2 that makes the best use of the space, without sacrificing space inside the vehicle cabin, is able to be realized.

Next, a plurality of modified examples of the inflow portion 3B and the outflow portion 3C will be described. Here, a modified example of the first example embodiment described above will be described, but it may also be applied as a modified example of the other example embodiments.

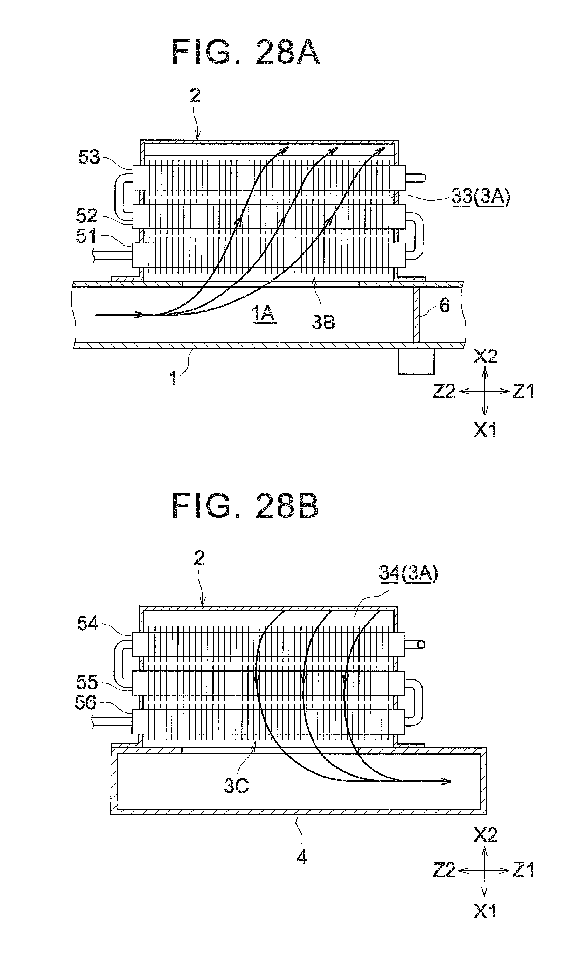

FIGS. 28A and 28B are views of a first modified example of the inflow portion 3B and the outflow portion 3C. FIG. 28A is a view corresponding to FIG. 2, and FIG. 28B is a view corresponding to FIG. 3.

With the structures shown in FIGS. 28A and 28B, an opening position in a Z direction (a length direction of the exhaust passage 1A) of the inflow portion 3B and the opening position in the Z direction of the outflow portion 3C are aligned with each other. That is, the inflow portion 3B and the outflow portion 3C are not offset in the flow direction of exhaust gas in the exhaust passage 1A.

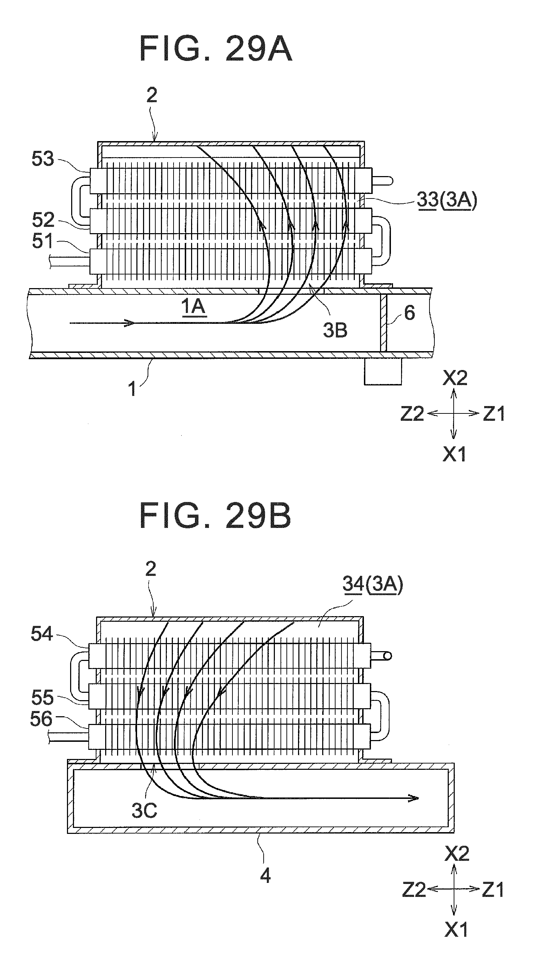

FIGS. 29A and 29B are views of a second modified example of the inflow portion 3B and the outflow portion 3C. FIG. 29A corresponds to FIG. 2, and FIG. 29B corresponds to FIG. 3.

With the structures shown in FIGS. 29A and 29B, the offset amount (i.e., the offset amount in the Z direction) between the opening position of the inflow portion 3B and the opening position of the outflow portion 3C is large. That is, the opening position of the inflow portion 3B is offset toward the Z1 direction side, and the opening position of the outflow portion 3C is offset toward the Z2 direction side.

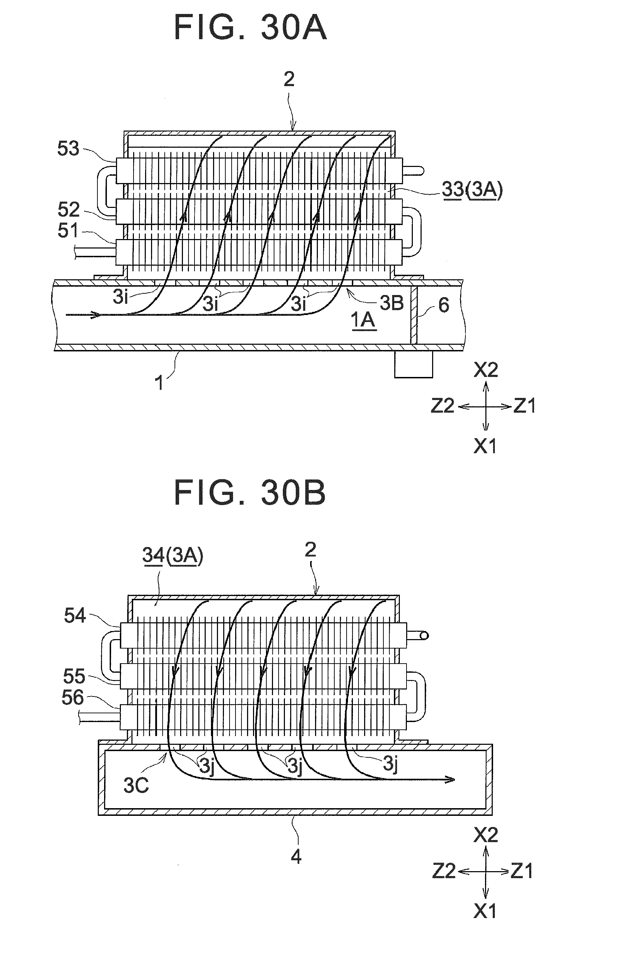

FIGS. 30A and 30B are views of a third modified example of the inflow portion 3B and the outflow portion 3C. FIG. 30A corresponds to FIG. 2, and FIG. 30B corresponds to FIG. 3.

With the structure shown in FIG. 30, the inflow portion 3B and the outflow portion 3C are formed by openings 3i and 3j, respectively, that are formed intermittently in the Z direction.

According to this structure, the exhaust gas that flows through the branch passage 3A is able to be regulated, and exhaust gas is able to flow over almost the entire length of each of the thermoelectric modules 51 to 56, as shown by the arrows in the drawings.

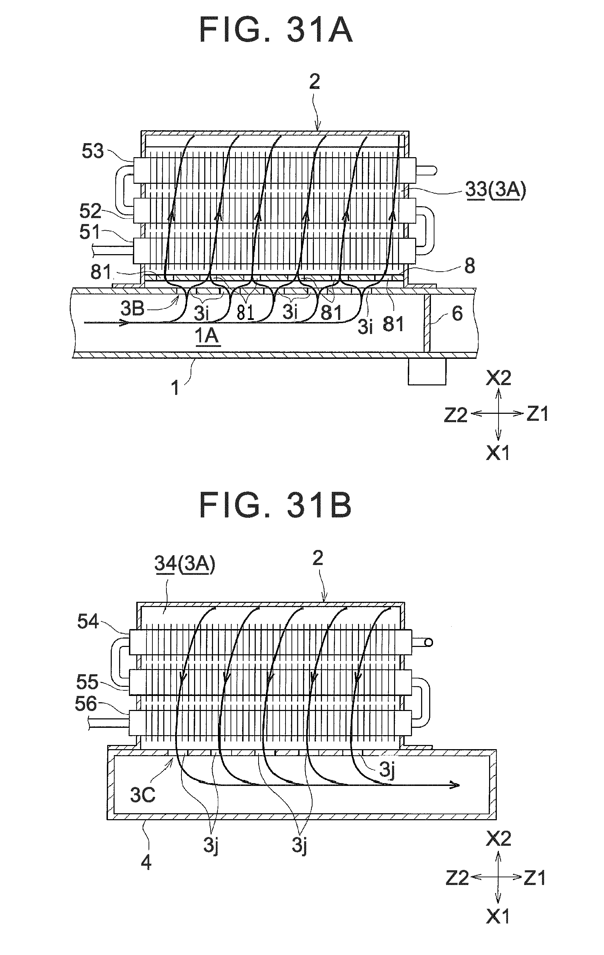

FIGS. 31A and 31B are views of a fourth modified example of the inflow portion 3B and the outflow portion 3C. FIG. 31A corresponds to FIG. 2, and FIG. 31B corresponds to FIG. 3.

With the structure shown in FIGS. 31A and 31B, in addition to the structure of the third modified example described above, a baffle plate (rectifying member) 8 is arranged facing the inflow portion 3B, inside the casing 31, i.e., between the inflow portion 3B and the first thermoelectric module 51 positioned farthest upstream in the flow direction of exhaust gas in the branch passage 3A. The baffle plate 8 is also provided with openings 81 intermittently in the Z direction. The positions of the openings 3i and the positions of the openings 81 in the baffle plate 8 are offset in the Z direction, and do not face each other in the X direction.

According to this structure, the exhaust gas rectifying effect is able to be even better produced, and exhaust gas is able to flow over almost the entire length of each of the thermoelectric modules 51 to 56, as shown by the arrows in the drawings.

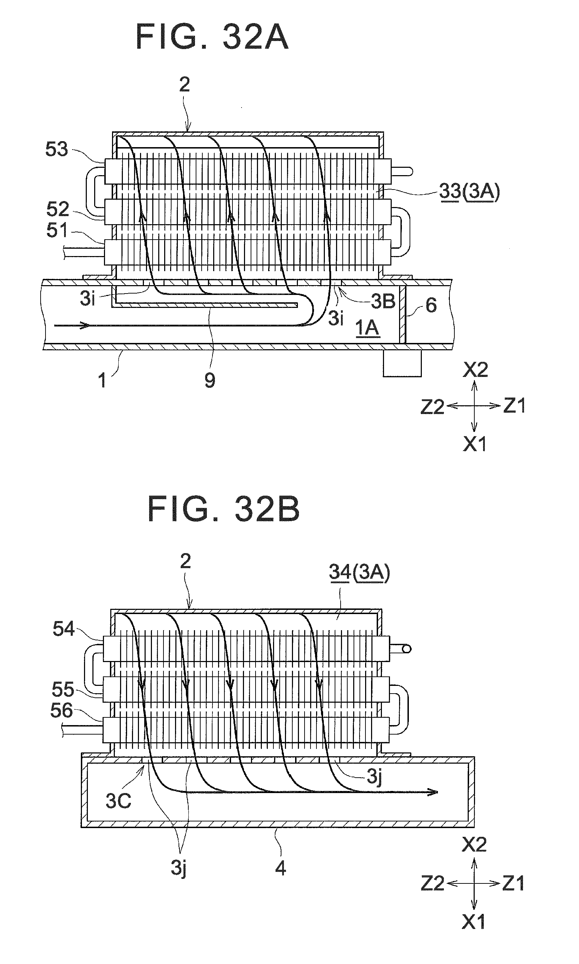

FIGS. 32A and 32B are views of a fifth modified example of the inflow portion 3B and the outflow portion 3C. FIG. 32A corresponds to FIG. 2, and FIG. 32B corresponds to FIG. 3.

In the structures shown in FIGS. 32A and 32B, in addition to the structure of the third modified example described above, a guide plate (a restricting plate) 9 is arranged facing the inflow portion 3B, on the of outside (the exhaust passage 1A side) of the casing 31. The guide plate 9 both covers an upstream side region, in the exhaust gas flow direction in the exhaust passage 1A, and exposes a downstream side region, of an open area (i.e., an open area in the Z direction) of the inflow portion 3B.

According to this structure, the exhaust gas rectifying effect is able to be even better produced, and exhaust gas is able to flow along almost the entire length of each of the thermoelectric modules 51 to 56, as shown by the arrows in the drawings.

The structures of the modified examples described above may be combined.

Next, a plurality of modified examples of the casing 31 will be described. Here as well, a modified example of the first example embodiment described above will be described, but it may also be applied as a modified example of the other example embodiments.

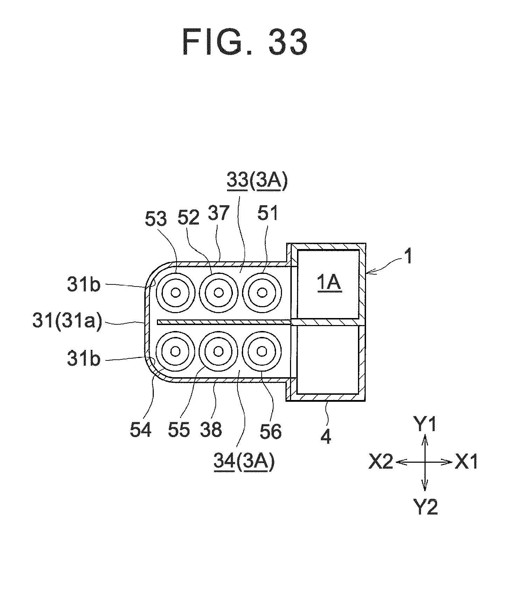

FIG. 33 is a view corresponding to FIG. 6, of a sixth modified example.

As shown in FIG. 33, a boundary portion between a top plate 37 and a vertical plate 31a positioned on the X2 direction side of the casing 31, and a boundary portion between this vertical plate 31a and a bottom plate 38, are both curved, and inside surfaces of these curved portions are formed as guide surfaces 31b that follow the flow direction of the exhaust gas that reverses. The curvature of these guide surfaces 31b substantially matches the curvature of the outside surface of the thermoelectric modules 51 to 56, for example (for example, the curvature of the outer edge of the heat receiving fins 51d).

Accordingly, when the flow direction of the exhaust gas reverses from the upper passage 33 toward the lower passage 34, the amount of decrease in the flow rate of the exhaust gas is able to be reduced, so the flow rate of exhaust gas that flows into the lower passage 34 is able to be kept high. Therefore, a sufficient mass flow rate of exhaust gas that flows around the thermoelectric modules 54, 55, and 56 that are arranged in the lower passage 34 is able to be obtained, so boundary film heat resistance around the outer peripheries of the thermoelectric modules 54, 55, and 56 is able to be suppressed, and thus a large amount of waste heat is able to be recovered.

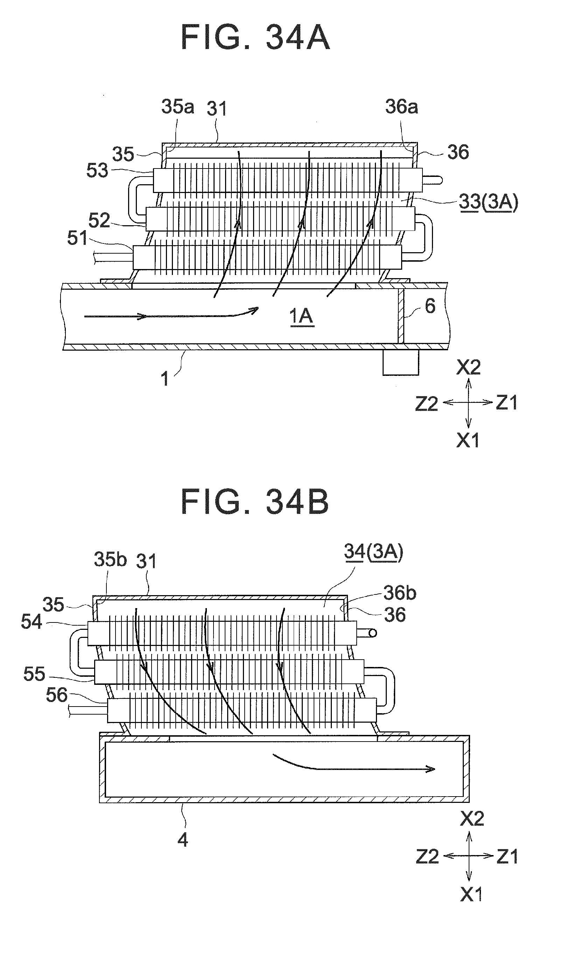

FIGS. 34A and 34B are views of a seventh modified example. FIG. 34A corresponds to FIG. 2, and FIG. 34B corresponds to FIG. 3.

As shown in FIGS 34A and 34B, a front plate 35 and a rear plate 36 of the casing 31 are curved following the flow direction of exhaust gas, and inside surfaces of these curved portions are formed as guide surfaces 35a, 35b, 36a, and 36b. More specifically, the guide surfaces 35a and 36a of the front plate 35 and the rear plate 36 that form the upper passage 33 are curved surfaces that curve toward the Z1 direction side as they extend toward the X2 direction side. Also, the guide surfaces 35b and 36b of the front plate 35 and the rear plate 36 that form the lower passage 34 are curved surfaces that curve toward the Z1 direction side as they extend toward the X1 direction side.

Accordingly, the amount of decrease in the flow rate of the exhaust gas that flows into the upper passage 33 and the exhaust gas that flows through the lower passage 34 is able to be reduced, so the flow rate of exhaust gas in both the upper passage 33 and the lower passage 34 is able to be kept high. Therefore, a sufficient mass flow rate of exhaust gas that flows around the outer peripheries of the thermoelectric modules 51 to 56 is able to be obtained, so boundary film heat resistance around the outer peripheries of the thermoelectric modules 51 to 56 is able to be suppressed, and thus a large amount of waste heat is able to be recovered.

In the example embodiments and modified examples described above, a case in which the invention has been applied to the thermoelectric generator 2 provided in an exhaust system of a vehicle engine is described. The invention is not limited to this, and may also be applied to a thermoelectric generator provided in an exhaust system used for a purpose other than a vehicle.

The number of thermoelectric modules 51 to 56 provided in the thermoelectric generator 2, and the layout of these thermoelectric modules 51 to 56, are not limited to those of the example embodiments described above, and may be set as appropriate. In particular, the number of thermoelectric modules 51 to 56 may be changed appropriately according to the mounting space below the floor panel and the required electric generating capacity. Therefore, the invention can also be applied to a relatively small vehicle, or to a vehicle in which the space below the tunnel portion 71 of the floor panel 7 is relatively small, by reducing the number of thermoelectric modules 51 to 56.

In the example embodiments and modified examples described above, the on-off valve 6 is operated by the electric motor 62. The invention is not limited to this. For example, the on-off valve 6 may be formed by an electromagnetic valve, or a thermostat may be incorporated and the opening may be changed according to the temperature of the exhaust gas.

In the example embodiments and modified examples, exhaust gas that has flowed in from the exhaust passage 1A to the branch passage 3A and heated the thermoelectric modules 51 to 56 returns again to the exhaust passage 1A. The invention is not limited to this. Exhaust gas that heated the thermoelectric modules 51 to 56 may also be released into the atmosphere without returning to the exhaust passage 1A. However, in this case, in order to prevent exhaust gas emissions of the exhaust gas discharged from the branch passage 3A from deteriorating, it is necessary to provide a separate exhaust gas control apparatus.

In the example embodiments and modified examples other than the fourth example embodiment, the plurality of heat receiving fins 51d are each formed by independent circular plates. The invention is not limited to this. Spiral shaped heat receiving fins may also be used.

The example embodiments described above may be applied to a thermoelectric generator that generates electricity using heat energy of exhaust gas discharged from an engine.

A thermoelectric generator that generates electricity using heat energy of exhaust gas, the thermoelectric generator comprising: an inflow portion into which exhaust gas flows from an exhaust passage; an outflow portion out of which exhaust gas flows; a branch passage that carries exhaust gas that has flowed in from the inflow portion toward the outflow portion; a plurality of thermoelectric modules arranged inside the branch passage, a length direction of each thermoelectric module of the plurality of thermoelectric modules being the same direction as a flow direction of exhaust gas in the exhaust passage, the plurality of thermoelectric modules being arranged in series in an exhaust gas flow direction from the inflow portion toward the outflow portion; and at least one wall that defines the branch passage, and the at least one wall being such that exhaust gas flows along both sides of the at least one wall.

## Claims

1. A thermoelectric generator (2) that generates electricity using heat energy of exhaust gas that flows through an exhaust system of an internal combustion engine, the thermoelectric generator **characterized by** comprising:
an inflow portion (3B) into which exhaust gas flows from an exhaust passage (1A) of the exhaust system;
an outflow portion (3C) out of which exhaust gas flows;
a branch passage (3A) that carries exhaust gas that has flowed in from the inflow portion toward the outflow portion;
a plurality of thermoelectric modules (51, 52, 53, 54, 55, 56) arranged inside the branch passage, a length direction of each thermoelectric module of the plurality of thermoelectric modules being the same direction as a flow direction of exhaust gas in the exhaust passage, the plurality of thermoelectric modules being arranged in series in an exhaust gas flow direction from the inflow portion toward the outflow portion; and
at least one wall (3a, 3b, 3c, 32, 32A) that defines the branch passage, and the at least one wall being such that exhaust gas flows along both sides of the at least one wall.

2. The thermoelectric generator according to claim 1, wherein
the exhaust gas flow direction from the inflow portion toward the outflow portion in the branch passage is a direction that intersects the flow direction of exhaust gas in the exhaust passage; and
the plurality of thermoelectric modules arranged in the branch passage are arranged in series in the direction that intersects the flow direction of exhaust gas in the exhaust passage.

3. The thermoelectric generator according to claim 1, wherein
the exhaust gas flow direction from the inflow portion toward the outflow portion in the branch passage is the same direction as the flow direction of exhaust gas in the exhaust passage; and
the plurality of thermoelectric modules arranged in the branch passage are arranged in series in the same direction as the flow direction of exhaust gas in the exhaust passage.

4. The thermoelectric generator according to any one of claims 1 to 3, wherein
each of the thermoelectric modules includes a plurality of heat receiving fins (51d) on an outer surface of each of the thermoelectric modules,
the plurality of heat receiving fins are provided in the flow direction of exhaust gas in the branch passage.

5. The thermoelectric generator according to claim 1 or 2, wherein
the branch passage includes an upstream side passage (33) and a downstream side passage (34), the upstream side passage carries exhaust gas that has flowed in from the exhaust passage through the inflow portion in one direction, the downstream side passage carries exhaust gas that has flowed through the upstream side passage toward the outflow portion in the opposite direction of the flow in the upstream side passage; and
the upstream side passage and the downstream side passage are adjacent to each other, with the at least one wall between the upstream side passage and the downstream side passage, in a direction orthogonal to the flow direction of exhaust gas in the upstream side passage and the flow direction of exhaust gas in the downstream side passage.

6. The thermoelectric generator according to claim 5, further comprising
a casing (31) that defines the branch passage, wherein
the at least one wall is a partition that partitions an inside of the casing into the upstream side passage and the downstream side passage;
the upstream side passage and the downstream side passage are communicated by a communication path (S) arranged between the partition and a casing inside surface; and
exhaust gas that has flowed into the upstream side passage through the inflow portion flows into the downstream side passage through the communication path.

7. The thermoelectric generator according to claim 6, wherein
the inflow portion and the outflow portion are provided in positions offset from each other in the same direction as the flow direction of exhaust gas in the exhaust passage.

8. The thermoelectric generator according to claim 5, further comprising
a casing (31) that defines the branch passage, wherein
the at least one wall is a partition that partitions an inside of the casing into the upstream side passage and the downstream side passage;
the upstream side passage and the downstream side passage are communicated by a communication hole (32a) arranged in the partition; and
exhaust gas that has flowed into the upstream side passage through the inflow portion flows into the downstream side passage through the communication hole.

9. The thermoelectric generator according to claim 8, wherein
the inflow portion and the outflow portion are provided in positions offset from each other in the same direction as the flow direction of exhaust gas in the exhaust passage.

10. The thermoelectric generator according to any one of claims 1 to 9, wherein
the at least one wall provided with the inflow portion is facing the exhaust passage.

11. The thermoelectric generator according to claim 1 or 2, wherein
the branch passage is configured to cover an outer periphery of a portion of the exhaust passage; and
the at least one wall is disposed on the exhaust passage side, and the at least one wall faces facing the exhaust passage.

12. The thermoelectric generator according to claim 11, wherein
the branch passage is configured to cover an outer periphery of a portion of the exhaust passage along an entire circumferential direction of the exhaust passage; and
the at least one wall is disposed on the exhaust passage side, and the entire area of the at least one wall faces the exhaust passage.

13. The thermoelectric generator according to any one of claims 1 to 12, wherein
the inflow portion is an opening that extends in the flow direction of exhaust gas in the exhaust passage.

14. The thermoelectric generator according to any one of claims 1 to 12, wherein
the inflow portion is configured by a plurality of openings that are disposed in a plurality of locations in the flow direction of exhaust gas in the exhaust passage.

15. The thermoelectric generator according to any one of claims 1 to 14, further comprising:
a rectifying member (8) provided between the inflow portion and a thermoelectric module, of the plurality of the thermoelectric module, arranged in a position farthest upstream in the flow direction of exhaust gas in the branch passage, and the rectifying member being configured to rectify the flow of exhaust gas that flows from the inflow portion toward the thermoelectric module.

16. The thermoelectric generator according to any one of claims 1 to 14, further comprising:
a restricting member (9) provided in the exhaust passage, and the restricting member being configured to cover an upstream side region, in the exhaust gas flow direction in the exhaust passage, of an open area of the inflow portion, and the restricting member being configured to expose a downstream side region, in the flow direction of exhaust gas of the exhaust passage, of the open area of the inflow portion.

17. The thermoelectric generator according to any one of claims 1 to 16, further comprising:
an on-off valve (6, 6A, 6B, 6C, 6D) provided in the exhaust passage on a downstream side, in the flow direction of exhaust gas, of a position where the inflow portion is arranged in the exhaust passage, and the on-off valve being configured to open and close the exhaust passage.

18. The thermoelectric generator according to claim 1 or 2, further comprising:
a return duct (4) provided between the exhaust passage and the outflow portion of the branch passage, and the return duct being configured to return exhaust gas that has flowed out from the outflow portion to the exhaust passage;
an on-off valve (6, 6A, 6B, 6C, 6D) provided in the exhaust passage on a downstream side, in the flow direction of exhaust gas, of a position where the inflow portion is arranged in the exhaust passage; and
an electronic control unit (100) configured to shut off a communication between the return duct and the exhaust passage by the on-off valve when opening the exhaust passage, and communicate the return duct with the exhaust passage by the on-off valve when closing the exhaust passage.
